(19) Europäisches Patentamt / European Patent Office / Office européen des brevets

(11) **EP 4 435 982 A1**

(12) **EUROPEAN PATENT APPLICATION**

(43) Date of publication:
25.09.2024 Bulletin 2024/39

(51) International Patent Classification (IPC):
*H01S 5/183* (2006.01)  *H01S 5/062* (2006.01)
*H01S 5/065* (2006.01)  *H01S 5/00* (2006.01)
*H01S 5/042* (2006.01)  *H01S 5/10* (2021.01)
*H01S 5/30* (2006.01)  *H01S 5/323* (2006.01)

(21) Application number: 24164203.2

(22) Date of filing: 18.03.2024

(52) Cooperative Patent Classification (CPC):
**H01S 5/06216; G01S 7/48; H01S 5/0658;**
**H01S 5/18313; H01S 5/18358;** H01S 5/0035;
H01S 5/0428; H01S 5/06226; H01S 5/1039;
H01S 5/18308; H01S 5/18347; H01S 5/18361;
H01S 5/3095; H01S 5/32308

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: 23.03.2023 JP 2023046908

(71) Applicant: Ricoh Company, Ltd.
Tokyo 143-8555 (JP)

(72) Inventors:
• **UENO, Naofumi**
**Tokyo, 143-8555 (JP)**
• **JIKUTANI, Naoto**
**Tokyo, 143-8555 (JP)**

(74) Representative: **SSM Sandmair**
**Patentanwälte Rechtsanwalt**
**Partnerschaft mbB**
**Joseph-Wild-Straße 20**
**81829 München (DE)**

(54) **SURFACE-EMITTING LASER, LASER DEVICE, DETECTION DEVICE, MOBILE OBJECT, INFORMATION TERMINAL APPARATUS, AND METHOD FOR DRIVING SURFACE-EMITTING LASER**

(57) A surface-emitting laser (100) includes a resonator (100C1) and an electrode pair (160, 170) connected to a power supply, through which a current is injected into an active layer (130). The resonator (100C1) includes the active layer (130); a first reflector (120); and a second reflector (140). The resonator (100C1) has an optical thickness 1.5 times or more than a wavelength of the laser beam in a vacuum. The surface-emitting laser (100) does not oscillate the laser beam during a current injection period in which the power supply injects the current into the active layer (130) through the electrode pair (160, 170); and oscillates and emits the laser beam during a current decrease period after the current injection period. The current injected into the active layer (130) during the current decrease period is lower than the current injected into the active layer (130) during the current injection period.

FIG. 1

**Description**

BACKGROUND

Technical Field

Embodiments of the present disclosure relate to a surface-emitting laser, a laser device, a detection device, a mobile object, an information terminal apparatus, and a method for driving the surface-emitting laser.

Related Art

The laser safety standards for human eyes are classified in accordance with the classes of eye-safe, and are set in IEC 60825-1 Ed. 3, which corresponds to Japanese Industrial Standard (JIS) C 6802.

For using distance measurement devices in various environments, it is preferable to satisfy Class 1 standards, which do not require safety measures or warnings. The upper limit of the average power is determined as one of the Class 1 standards. For pulsed light, the peak output, the pulse width, and the duty ratio of the pulsed light are converted into average power, which is then compared with standard values. As the pulse width of the optical pulse shortens, the permittable peak output increases. A laser-beam source with a high-peak output and a short-pulse width is beneficial for enhancing both precision and range in a time of flight (TOF) sensor while maintaining eye safety.

Methods to achieve pulses of 1 nanosecond (ns) or shorter include gain switching, Q-switching, and mode-locking. Gain switching is a method to achieve pulse widths of 100 picoseconds (ps) or less by using the relaxation oscillation phenomenon. As controlling the pulse current achieves such pulse widths, the configuration of the gain switching is simpler than the configuration of the Q-switching or mode-locking.

However, in gain switching, due to its reliance on the relaxation oscillation phenomenon, multiple pulse sequences are more likely to be emitted following the leading pulse. Additionally, after the relaxation oscillation has settled, tail light (tailing) with an extended pulse width is more likely to be produced. These phenomena are not desirable for application. For example, when using a single photon avalanche diode (SPAD) in Geiger mode detection, only the highest peak output is sensed. Having multiple pulses other than the target pulse results in noise. Additionally, the tail light represents unnecessary energy, posing challenges from an eye safety perspective.

There is room for study on a surface-emitting laser that generates short-pulse light with reduced tailing.

SUMMARY

In view of the above, an object of the present disclosure is to provide a surface-emitting laser, a laser device, a detection device, a mobile object, an information terminal apparatus, and a method for driving the surface-emitting laser, which achieves short-pulse light with reduced tailing.

An embodiment of the present disclosure provides a surface-emitting laser including a resonator and an electrode pair connected to a power supply, through which a current is injected into an active layer. The resonator includes the active layer to oscillate a laser beam; a first reflector; and a second reflector facing the first reflector with the active layer between the first reflector and the second reflector in an emission direction of the laser beam emitted from the surface-emitting laser. The resonator has an optical thickness 1.5 times or more than a wavelength of the laser beam in a vacuum. The surface-emitting laser does not oscillate the laser beam during a current injection period in which the power supply injects the current into the active layer through the electrode pair; and oscillates and emits the laser beam during a current decrease period after the current injection period. The current injected into the active layer during the current decrease period is lower than the current injected into the active layer during the current injection period.

An embodiment of the present disclosure provides a surface-emitting laser including a resonator and an electrode pair connected to a power supply, through which a current is injected into an active layer. The resonator includes the active layer to oscillate a laser beam, a first reflector, and a second reflector facing the first reflector with the active layer between the first reflector and the second reflector in an emission direction of the laser beam emitted from the surface-emitting laser. The resonator has an optical thickness 1.5 times or more than a wavelength of the laser beam in a vacuum. The active layer oscillates the laser beam having an optical pulse width that is: a time width of $1/e^2$ of a peak value of the laser beam, 110 ps or lower; and smaller than a time width of a current injection period in which the power supply injects the current into the active layer.

An embodiment of the present disclosure provides a laser device including the surface-emitting laser described above; and the power supply connected to the electrode pair, the power supply to inject the current into the surface-emitting laser.

An embodiment of the present disclosure provides a detection device including the laser device and a detector to detect light emitted from the surface-emitting laser and reflected from an object.

An embodiment of the present disclosure provides a mobile object including the detection device described above.

An embodiment of the present disclosure provides an information terminal apparatus including the detection device.

An embodiment of the present disclosure provides a method for driving a surface-emitting laser including oscillating no laser beam during a current injection period in which a power supply injects a current into an active layer; and oscillating a laser beam during a current decrease period after the current injection period. The current injected into the active layer during the current decrease period is lower than the current injected into the active layer during the current injection period.

Embodiments of the present disclosure achieve short-pulse light with reduced tailing.


BRIEF DESCRIPTION OF THE DRAWINGS

A more complete appreciation of the disclosure and many of the attendant advantages and features thereof can be readily obtained and understood from the following detailed description with reference to the accompanying drawings, wherein:

FIG. 1 is a cross-sectional view of a surface-emitting laser according to a first embodiment of the present disclosure;
FIG. 2 is a cross-sectional view of an oxidized confinement layer and the vicinity thereof according to the first embodiment;
FIG. 3 is a cross-sectional view of an oxidized confinement layer and the vicinity thereof according to a reference example of the present embodiment;
FIG. 4 is an equivalent circuit diagram illustrating a circuit used for actual measurement;
FIGS. 5A, 5B, and 5C are graphs each presenting actual measurement results according to a reference example of the present disclosure;
FIGS. 6A, 6B, and 6C are graphs each presenting actual measurement results according to the first embodiment;
FIGS. 7A and 7B are graphs each presenting differences in distributions of electric field intensity and equivalent refractive index due to a structure;
FIGS. 8A and 8B are graphs each presenting changes in distributions of electric field intensity and equivalent refractive index over time;
FIG. 9 is a graph presenting simulation results for carrier density and threshold carrier density according to a reference example of the present disclosure;
FIG. 10 is a graph presenting simulation results for optical output according to a reference example of the present disclosure;
FIG. 11 is a graph presenting a function used in a simulation according to the first embodiment;
FIG. 12 is a graph presenting simulation results for optical output according to the first embodiment;
FIG. 13A is a graph presenting simulation results for carrier density, threshold carrier density, and photon density according to the first embodiment;
FIG. 13B is a graph presenting simulation results for optical confinement factor in a lateral direction according to the first embodiment;
FIG. 14A is a partially enlarged graph of FIG. 13A;
FIG. 14B is a partially enlarged graph of FIG. 13B;
FIG. 15A is a graph presenting actual measurement results of optical pulses;
FIG. 15B is a graph presenting simulation results of optical pulses;
FIG. 16 is a cross-sectional view of a first model used for a simulation;
FIGS. 17A and 17B are graphs each illustrating a cross-sectional profile of an electric-field intensity distribution of a fundamental mode;
FIG. 18 is a graph presenting the calculated relation between the optical confinement factor, the thickness of an oxidized confinement layer, and the diameter of a non-oxidized region.
FIG. 19 is a graph presenting the calculated relation between the thickness of an oxidized confinement layer and the optical confinement factor for the first model;
FIG. 20 is a cross-sectional view of a second model used for a simulation;
FIG. 21 is a cross-sectional view of a third model used for a simulation;
FIG. 22 is a graph presenting the calculated relation between the amount of decrease in refractive index and the optical confinement factor for the second model and the third model;
FIG. 23 is a cross-sectional view of a fourth model used for a simulation;
FIG. 24 is a graph presenting the calculated relation between the thickness of an oxidized region at the position 3 micrometers ($\mu$m) outward from the boundary and the optical confinement factor for the fourth model;

FIG. 25 is a graph presenting the relationship between the current confinement area and the peak optical output, according to an embodiment of the present disclosure;

FIG. 26 is a cross-sectional view of a surface-emitting laser according to a second embodiment of the present disclosure;

FIGS. 27A and 27B are graphs each presenting simulation results with its horizontal axis indicating the current density injected into a resonator and its vertical axis indicating the carrier surface density of the resonator;

FIGS. 28A, 28B, 28C, and 28D are graphs each presenting the relation between a resonator length and a longitudinal mode of a resonator, according to an embodiment of the present disclosure;

FIGS. 29A and 29B are graphs each presenting simulation results with its horizontal axis indicating the current density injected into a resonator and its vertical axis indicating the carrier surface density of the resonator;

FIGS. 30A and 30B are graphs each comparing carrier surface density in a resonator between a surface-emitting laser with an oscillation wavelength of 940 nm for pulsed light and a surface-emitting laser with an oscillation wavelength of 780 nm for pulsed light;

FIG. 31 is a cross-sectional view of a surface-emitting laser according to a third embodiment of the present disclosure;

FIG. 32 is a diagram of a laser device according to a fourth embodiment of the present disclosure;

FIG. 33 is a graph presenting the relation between the duty ratio and the peak output of optical pulses;

FIG. 34 is a diagram of a distance measurement apparatus according to a fifth embodiment of the present disclosure;

FIG. 35 is a diagram of a mobile object according to a sixth embodiment of the present disclosure;

FIG. 36 is a diagram illustrating the configuration of an information processing apparatus according to a sixth embodiment of the present disclosure; and

FIG. 37 is another diagram illustrating the configuration of the information processing terminal apparatus in FIG. 6.

The accompanying drawings are intended to depict embodiments of the present invention and should not be interpreted to limit the scope thereof. The accompanying drawings are not to be considered as drawn to scale unless explicitly noted. Also, identical or similar reference numerals designate identical or similar components throughout the several views.

DETAILED DESCRIPTION

In describing embodiments illustrated in the drawings, specific terminology is employed for the sake of clarity. However, the disclosure of this specification is not intended to be limited to the specific terminology so selected and it is to be understood that each specific element includes all technical equivalents that have a similar function, operate in a similar manner, and achieve a similar result.

Referring now to the drawings, embodiments of the present disclosure are described below. As used herein, the singular forms "a," "an," and "the" are intended to include the plural forms as well, unless the context clearly indicates otherwise.

Methods to achieve pulses shorter than 1 nanosecond (ns) include gain switching, Q-switching, and mode-locking. Gain switching is a method to achieve pulse widths of 100 picoseconds (ps) or less by using the relaxation oscillation phenomenon. As controlling the pulse current achieves such pulse widths, the configuration of the gain-switching is simpler than the configuration of the Q-switching or mode-locking.

However, in gain switching, due to its reliance on the relaxation oscillation phenomenon, multiple pulse sequences are more likely to be emitted following the leading pulse. Additionally, after the relaxation oscillation has settled, tail light (tailing) with an extended pulse width is more likely to be produced. These phenomena are not desirable for application. For example, when using a single photon avalanche diode (SPAD) in Geiger mode detection, only the highest peak output is sensed. Having multiple pulses other than the target pulse results in noise. Additionally, the tail light represents unnecessary energy, posing challenges from an eye safety perspective.

There is room for study on a surface-emitting laser that generates short-pulse light with reduced tailing.

Embodiments of the present disclosure are described below with reference to the accompanying drawings. In the description and the drawings of the embodiments of the present disclosure, like reference signs may be given to like elements with substantially the same functional configuration. Accordingly, overlapping descriptions are omitted where appropriate.

First Embodiment

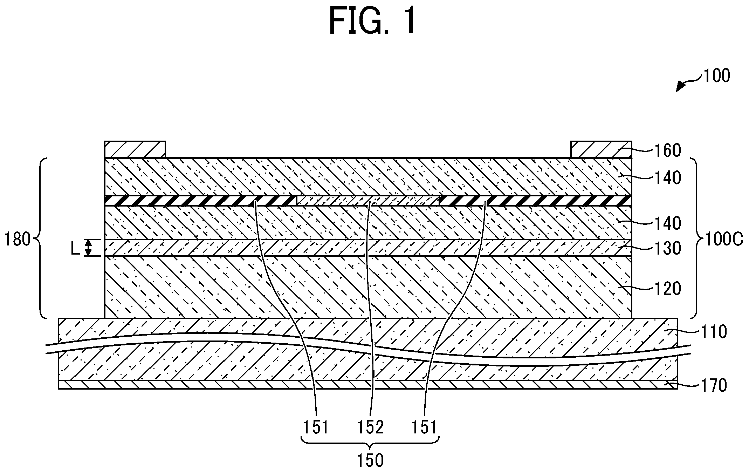

The first embodiment of the present disclosure is described below. The first embodiment relates to a surface-emitting laser. FIG. 1 is a cross-sectional view of a surface-emitting laser 100 according to the first embodiment.

The surface-emitting laser 100 according to the first embodiment is, for example, a vertical-cavity surface-emitting laser (VCSEL) using oxidation confinement. The surface-emitting laser 100 includes an n-type GaAs substrate 110, an n-type distributed Bragg reflector (DBR) 120, an active layer 130, a p-type DBR 140, an oxidized confinement layer 150, an upper electrode 160, and a lower electrode 170.

In the present embodiment, light is emitted in a direction perpendicular to a surface of the n-type GaAs substrate 110. In the following description, the direction perpendicular to the surface of the n-type GaAs substrate 110 may be referred to as a vertical direction, and the direction parallel to the surface of the n-type GaAs substrate 110 may be referred to as a lateral direction or an in-plane direction. The vertical direction serves as a first direction, or the emission direction of a laser beam emitted from the surface-emitting laser 100.

The n-type DBR 120 is on the n-type GaAs substrate 110. The n-type DBR 120 is, for example, a semiconductor multilayer-film reflecting mirror including multiple n-type semiconductor films stacked on one another. The active layer 130 is on the n-type DBR 120. The active layer 130 includes, for example, multiple quantum well layers and multiple barrier layers.

The p-type DBR 140 is on the active layer 130. The p-DBR 147 is, for example, a semiconducting multilayer reflector including multiple p-type semiconductor films that are multilayered.

In the surface-emitting laser 100 according to the first embodiment, the n-type DBR 120, the active layer 130, and the p-type DBR 140 form a resonator 100C. In the resonator 100C, the active layer 130 is positioned closer to the antinode of a standing wave of lasing light (or a laser beam) than the midpoint between the antinode and the node. When the active layer 130 is positioned at the antinode of a standing wave, emission efficiency is maximized.

The cavity length L of the resonator 100C according to the first embodiment corresponds to the optical thickness between the n-type DBR 120 and the p-type DBR 140. In the first embodiment, the optical thickness of the active layer 130 between the n-type DBR 120 and the p-type DBR 140 corresponds to the cavity length L.

The resonator length L satisfies the conditions of Equation (1) in relation to the oscillation wavelength λ in vacuum.

[Equation 1]

$$L = (\lambda \,/\, 2) \times n \qquad (1)$$

However, n is a natural number, not including zero (0).

The upper electrode 160 contacts the upper surface of the p-type DBR 140. The lower electrode 170 contacts the lower surface of the n-type GaAs substrate 110. The pair of the upper electrode 160 and the lower electrode 170 serves as an electrode pair. However, the positions of the electrodes are not limited thereto and may be any positions as far as the electrodes can inject current into the active layer. For example, an intracavity structure may be employed in which electrodes are disposed directly on a spacer layer of the resonator, rather than being intervened by the DBRs.

The p-type DBR 140 includes, for example, the oxidized confinement layer 150. The oxidized confinement layer 150 contains aluminum (Al). The oxidized confinement layer 150 includes an oxidized region 151 and a non-oxidized region 152 in a plane perpendicular to the direction of light emission. The oxidized region 151 has an annular planar shape and surrounds the non-oxidized region 152. The non-oxidized region 152 includes a p-type AlAs layer 155 and two p-type $Al_{0.85}Ga_{0.15}As$ layers 156 that sandwich the p-type AlAs layer 155 in the vertical direction. The oxidized region 151 contains $AlO_x$. The refractive index of the oxidized region 151 is lower than the refractive index of the non-oxidized region 152.

For example, the refractive index of the oxidized region 151 is 1.65, the refractive index of the p-type AlAs layer 155 is 2.96, and the refractive index of the p-type $Al_{0.85}Ga_{0.15}As$ layers 156 is 3.04. In plan view, a portion of a mesa 180 inside an inner edge of the oxidized region 151 serves as a high refractive index region, and a portion of the mesa 180 outside the inner edge of the oxidized region 151 serves as a low refractive index region.

Thus, the first refractive index region (non-oxidized region 152) and the second refractive index region (oxidized region 151) are within a plane orthogonal to the emission direction.

In one example, p-type $Al_xGa_{1-x}As$ layers ($0.70 \leq x \leq 0.90$) are placed instead of the p-type $Al_{0.85}Ga_{0.15}As$ layers 156. In the present embodiment, the p-type DBR 140, the active layer 130, and the n-type DBR 120 form the mesa 180. However, in the present embodiment with a current confinement region formed by oxidation confinement, at least the oxidized confinement layer 150 and a semiconductor layer located above the oxidized confinement layer 150 are formed in a mesa shape. By forming at least the active layer within the mesa, light produced in the active layer can be prevented from leaking in the lateral direction.

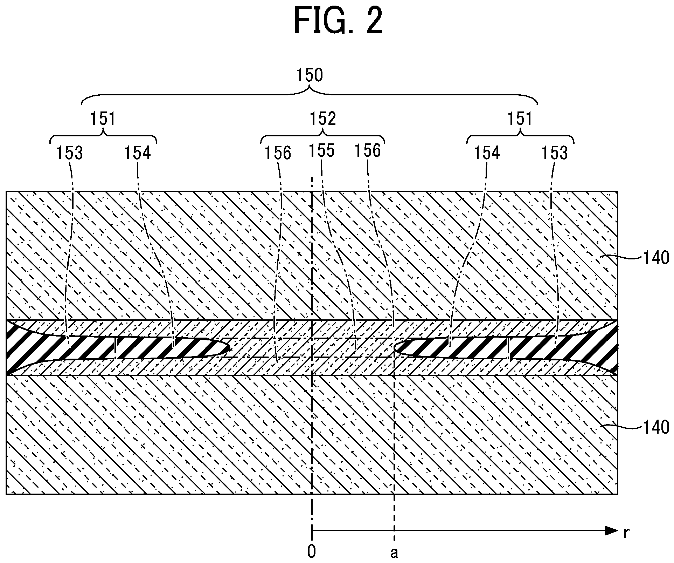

The oxidized confinement layer 150 is described in detail below. FIG. 2 is a cross-sectional view of an oxidized confinement layer and the vicinity thereof according to the first embodiment.

As illustrated in FIG. 2, the oxidized region 151 has an annular outer region 153 and an annular inner region 154 in a plan view (i.e., in the in-plane direction). The outer region 153 is exposed from a side surface of the mesa 180. In cross-sectional view, the outer region 153 has a varying thickness in the vertical direction such that its contact surface (i.e., the surface of the outer region 153) lies further outward in the lateral direction within the oxidized region 151. In cross-sectional view, the inner region 154 has a varying thickness in the vertical direction such that its contact surface (i.e., the surface of the inner region 154) lies further inward within the oxidized region 151. The inner region 154 is located inside the outer region 153 in the lateral direction. The thickness of the inner region 154 matches the thickness of the outer region 153 at their boundary and decreases toward the center 0 of the mesa 180. The inner region 154 has a tapered shape that is gradually thicker from the inner edge to the boundary with the outer region 153 in cross-sectional view. The non-oxidized region 152 is located inside the outer region 153. The inner region 154 is sandwiched by portions of the non-oxidized region 152 in the vertical direction. Another portion of the non-oxidized region 152 is located inside the inner edge of the inner region 154 in a plan view. For example, the thickness of the non-oxidized region 152 is 35 nanometers (nm) or less. The thickness of the outer region 153 may be larger than the thickness of the non-oxidized region 152. In the present disclosure, the thickness of the non-oxidized region 152 refers to the thickness of a portion of the non-oxidized region 152 at a position closer to the center 0 of the mesa 180 than to the inner edge a of the oxidized region 151 (i.e., the inner edge of the inner region 154) in the lateral direction. For example, the distance from the side surface of the mesa 180 to the inner edge of the oxidized region 151 is in a range from about 8 micrometers ($\mu$m) to about 11 $\mu$m.

The oxidized region 151 is formed by, for example, oxidation confinement of a p-type AlAs layer and a p-type $Al_{0.85}Ga_{0.15}As$ layer. For example, the oxidized region 151 can be formed by oxidizing the p-type AlAs layer and the p-type $Al_{0.85}Ga_{0.15}As$ layer in a high-temperature water vapor environment. Even when the same p-type AlAs layer and p-type $Al_{0.85}Ga_{0.15}As$ layer are oxidized, the structure of the oxidized confinement layer obtained from the p-type AlAs layer and the p-type $Al_{0.85}Ga_{0.15}As$ layer may differ depending on the oxidation conditions. Thus, even when the layers, such as the p-type AlAs layer and the p-type $Al_{0.85}Ga_{0.15}As$ layer, that are intended to become the oxidized confinement layer 150 have the same structures as those before oxidation, the oxidized confinement layer 150 including the oxidized region 151 and the non-oxidized region 152 may not be obtained depending on the oxidation conditions.

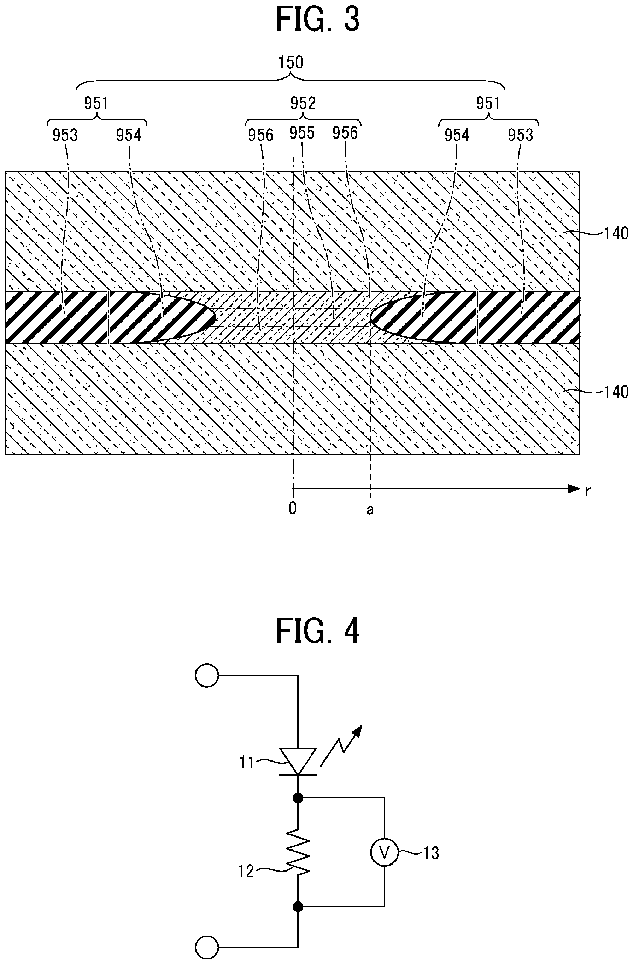

The advantageous effects of the first embodiment are described below in comparison with a reference example of the present disclosure. FIG. 3 is a cross-sectional view of an oxidized confinement layer and the vicinity thereof according to a reference example of the present disclosure.

In the reference example, the oxidized confinement layer 150 includes an oxidized region 951 and a non-oxidized region 952 instead of the oxidized region 151 and the non-oxidized region 152. The oxidized region 951 has an annular planar shape and surrounds the non-oxidized region 952. The non-oxidized region 952 includes a p-type AlAs layer 955 and two p-type $Al_{0.85}Ga_{0.15}As$ layers 956 that sandwich the p-type AlAs layer 955 in the vertical direction. The oxidized region 951 contains $AlO_x$. The oxidized region 951 has, in plan view, an annular outer region 953 and an annular inner region 954. The outer region 953 is exposed from a side surface of a mesa 180. The thickness of the outer region 953 is constant in the in-plane direction. The inner region 954 is located inside the outer region 953 in the in-plane direction. The thickness of the inner region 954 matches the thickness of the outer region 953 at the boundary between the inner region 954 and the outer region 953 and decreases toward the center 0 of the mesa 180.

In cross-sectional view, the inner region 954 has a tapered shape that gradually thickens from an inner edge to the boundary with the outer region 953. The non-oxidized region 952 is located inside the outer region 953 in the in-plane direction. The inner region 954 is sandwiched by portions of the non-oxidized region 952 in the vertical direction. Another portion of the non-oxidized region 952 is located inside the inner edge of the inner region 954 in a plan view. For example, the distance from the side surface of the mesa 180 to the inner edge of the oxidized region 951 is in a range from about 8 $\mu$m to about 11 $\mu$m. The thicknesses of the oxidized region 951 and the non-oxidized region 952 are equal to the thickness of the oxidized confinement layer 150.

Actual measurement results according to the first embodiment and the reference example are described below. FIG. 4 is an equivalent circuit diagram illustrating a circuit used for actual measurement.

In this circuit, a resistor 12 for monitoring current is connected in series to a surface-emitting laser 11, which corresponds to the first embodiment or the reference example. A voltmeter 13 is connected in parallel to the resistor 12. Light output from the surface-emitting laser 11 was received by a wide-band high-speed photodiode and converted into a voltage signal. The voltage signal was observed with an oscilloscope.

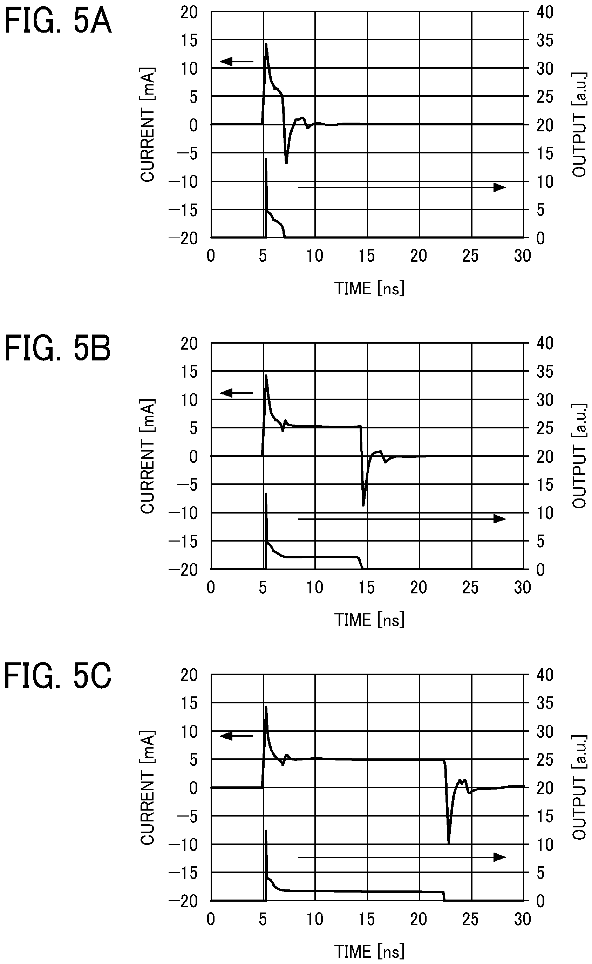

FIGS. 5A, 5B, and 5C are graphs each presenting actual measurement results according to the reference example. FIG. 5A presents actual measurement results when the width of the pulse current is about 2 nanoseconds (ns). FIG. 5B presents actual measurement results when the width of the pulse current is about 9 ns. FIG. 5C presents actual measurement results when the width of the pulse current is about 17 ns. In the actual measurement in FIGS. 5A to 5C, the magnitude of bias current and the amplitude of the pulse current are common. FIGs. 5A to 5C each present current flowing through the resistor 12 and an optical output measured by the high-speed photodiode. The current flowing through the resistor 12 can be calculated using the voltmeter 13.

As presented in FIGS. 5A to 5C, in the reference example, regardless of the magnitude of the width of the pulse current, an optical pulse is output immediately after the pulse current is injected, then an equilibrium state is established until the injection of the pulse current is stopped, and constant tail light is output. The leading optical pulse is caused by relaxation oscillation, which is typically driven by gain switching. Even when the pulse width is changed, the timing at which the optical pulse is generated does not change. This is because the optical pulse generated by the relaxation oscillation is generated immediately after the carrier density in the laser resonator exceeds the threshold carrier density. To reduce the output of the tail light, the current injection may be stopped immediately after the optical pulse is output. However, since the time width of the optical pulse caused by the relaxation oscillation is 100 ps or less when the magnitude of the current is as large as 10 A or more, it is difficult to stop the injection of the current in a period of 100 ps or less immediately after the optical pulse is output.

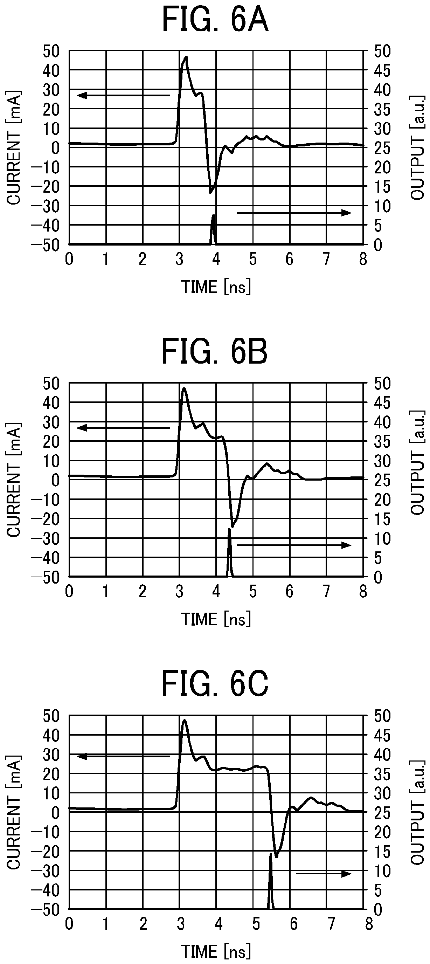

FIGS. 6A, 6B, and 6C are graphs each presenting actual measurement results according to the first embodiment. FIG. 6A presents actual measurement results when a pulse current has a width of about 0.8 ns. FIG. 6B presents actual measurement results when a pulse current has a width of about 1.3 ns. FIG. 6C presents actual measurement results when a pulse current has a width of about 2.5 ns. In the actual measurement in FIGS. 6A to 6C, both the magnitude of the bias current of the bias current and the amplitude of the pulse current are common. FIGS. 6A to 6C each present current flowing through the resistor 12 and an optical output measured by the high-speed photodiode. The current flowing through the resistor 12 can be calculated using the voltmeter 13.

As presented in FIGS. 6A to 6C, in the first embodiment, no light output occurs while the pulse current is being injected, and optical pulses are emitted immediately after the injection of the pulse current decreases. Further, tail light following the optical pulse emission is almost not observed. With an optical output by gain switching, the optical pulse timing remains constant irrespective of changes in pulse current width.

However, in the first embodiment, the optical pulse is emitted as the pulse current injection diminishes. Thus, the optical output according to the first embodiment is not based on the typical gain switching using the relaxation oscillation phenomenon.

As described above, the first embodiment and the reference example clearly differ from each other in the mechanism and mode of the optical output. The differences are described as follows.

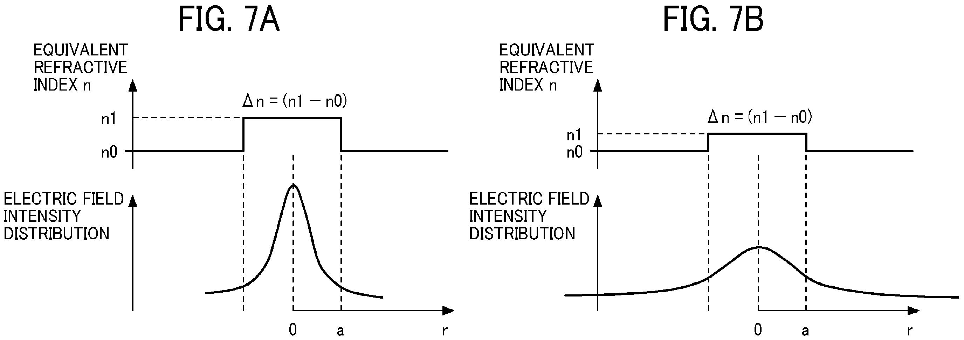

In a surface-emitting laser, a laser beam propagates through the resonator in a direction perpendicular to the oxidized confinement layer. Thus, as the oxidized confinement layer is thicker, an equivalent waveguide length, which is dependent on the difference in refractive index, increases, and an optical confinement effect in the lateral direction increases. When a DBR including the oxidized confinement layer is considered to be an equivalent waveguide structure, the electric-field intensity distribution of laser beams is concentrated around the center when the difference in equivalent refractive index is large as presented in FIG. 7A. In contrast, when the difference in equivalent refractive index is small as presented in FIG. 7B, the electric-field intensity distribution of laser beams expands to the oxidized region in the surrounding area of the non-oxidized region. When the first embodiment is compared with the reference example, since the oxidized confinement layer 150 includes the inner region 154 in the first embodiment, the difference in the equivalent refractive index decreases in the first embodiment. Thus, the electric-field intensity distribution of the laser beams is concentrated around the center in the reference example as presented in FIG. 7A. By contrast, in the first embodiment, the electric-field intensity distribution of the laser beams expands to the oxidized region 151 as presented in FIG. 7B.

In this case, an optical confinement factor in the lateral direction is defined as a ratio of "an integrated intensity of the electric field in a region having the same radius as a current passing region" to "an integrated intensity of an electric field in a lateral cross-section passing through the center of a surface-emitting laser element", and is given by Equation (2). In this case, a corresponds to a radius of the current passing region, and $\Phi$ represents a rotation direction around a rotation axis in the direction perpendicular to the substrate (the n-type GaAs substrate 110).

[Equation 2]

$$\Gamma_r = \frac{\int_0^a \int_0^{2\pi} |E|^2 \cdot r d\Phi dr}{\int_0^\infty \int_0^{2\pi} |E|^2 \cdot r d\Phi dr} \qquad (2)$$

A model of the phenomenon that occurs when the injection of the pulse current is stopped is described below. When pulse current is injected, the current path is concentrated near the center of the mesa due to the oxidized confinement layer, resulting in a high carrier density. At this time, in the non-oxidized region with high carrier density, the carrier plasma effect causes a reduction in the refractive index. The carrier plasma effect is a phenomenon where the refractive index decreases in proportion to the free carrier density. According to the literature 'Kobayashi, Soichi, et al. "Direct frequency modulation in AlGaAs semiconductor lasers." IEEE Transactions on Microwave Theory and Techniques 30.4 (1982): 428-441', the change in refractive index is given by Equation (3). In this case, N is a carrier density.

[Equation 3]

$$\Delta n \fallingdotseq -4 \times 10^{-21} [cm^3] \times N[1/cm^3] \qquad (3)$$

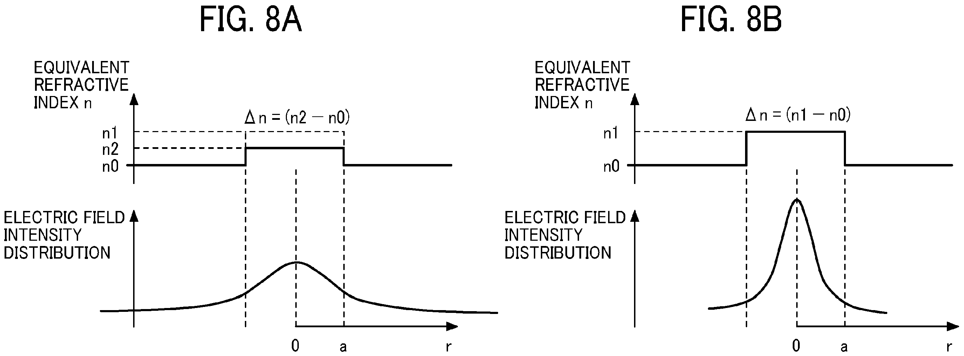

FIG. 8A schematically presents an equivalent refractive index and an electric field intensity distribution in a period in which pulse current is injected. FIG. 8B schematically presents an equivalent refractive index and an electric field intensity distribution in a period in which the injection of the pulse current is stopped and the pulse current decreases.

The carrier plasma effect acts in a direction to cancel out the equivalent refractive-index difference (n1 - n0) generated by the oxidized confinement layer in the period in which the pulse current is injected, and hence the equivalent refractive-index difference is (n2 - n0). When the injection of the pulse current decreases in this state, the carrier plasma effect no longer acts, and the equivalent refractive-index difference returns to (n1 - n0). As a result, photons that had spread to the periphery of the mesa are gathered in the central portion of the mesa, leading to an increase in photon density in the non-oxidized region. In other words, the lateral optical confinement becomes stronger. When the injection of the pulse current is stopped, carriers accumulated in the resonator decrease over the carrier lifetime. However, when the lateral optical confinement increases before the carrier density completely attenuates, induced emission starts, the accumulated carriers are consumed at once, and an optical pulse is output. The period during which the pulse current is injected is a current injection period, whereas the period during which the injection of the pulse current is stopped and the pulse current decreases is a current decrease period.

The results of validating the above model through a simulation are described below. The rate equations for carrier density and photon density are given by Equations (4) and (5).

[Equation 4]

$$\frac{dN}{dt} = \frac{i(t)}{eV} - \frac{N}{\tau_n(N)} - v_g g(N,S)S \qquad (4)$$

[Equation 5]

$$\frac{dS}{dt} = \left( \Gamma_a v_g g(N,S) - \frac{1}{\tau_p} \right) S + \frac{\Gamma_a \beta N}{\tau_n(N)} \qquad (5)$$

The meanings of the symbols in Equations (4) and (5) are as follows.

$N$: a carrier density (1/cm$^3$)
$S$: photon density (1/cm$^3$)
$i(t)$: injection current (A)
$e$: elementary charge amount (C)
$V$: resonator volume (cm$^3$)
$\tau_n(N)$: carrier lifetime (s)
$v_g$: group velocity (cm/s)
$g(N, S)$: a gain (1/cm)
$\Gamma_a$: an optical confinement factor
$\tau_p$: photon lifetime (s)
$\beta$: spontaneous emission coupling factor
$g_0$: gain coefficient (1/cm)
$\varepsilon$: gain control coefficient
$N_{tr}$: transparent carrier density (1/cm$^3$)
$\eta_i$: current injection efficiency
$\alpha_m$: resonator mirror loss (1/cm)
$h$: Planck constant (Js)
$v$: frequency of light (1/s)

The gain $g(N, S)$ is given by Equation (6).

[Equation 6]

$$g(N,S) = \frac{g_0}{1 + \varepsilon S} \ln \frac{N}{N_{tr}} \qquad (6)$$

As expressed in Equation (7), the optical confinement factor $\Gamma_a$ is defined by the product of an optical confinement factor $\Gamma_r$ in the lateral direction and an optical confinement factor $\Gamma_z$ in the vertical direction.
[Equation 7]

$$\Gamma_a = \Gamma_r \times \Gamma_z \qquad (7)$$

A threshold carrier density $N_{th}$ is given by Equation (8).
[Equation 8]

$$N_{th} = N_{tr} \cdot exp\left(\frac{1}{\Gamma_a \cdot g_0 \cdot v_g \cdot \tau_p}\right) \qquad (8)$$

A threshold current $I_{th}$ and the threshold carrier density $N_{th}$ have a relation given by Equation (9).
[Equation 9]

$$\frac{\eta_i \cdot I_{th}}{e \cdot V} = \frac{N_{th}}{\tau_n(N)} \qquad (9)$$

An optical output P that is output from the resonator and the photon density S have a relation given by Equation (10).
[Formula 10]

$$P = v_g \cdot \alpha_m \cdot S \cdot h\nu \cdot \frac{V}{\Gamma_a} \qquad (10)$$

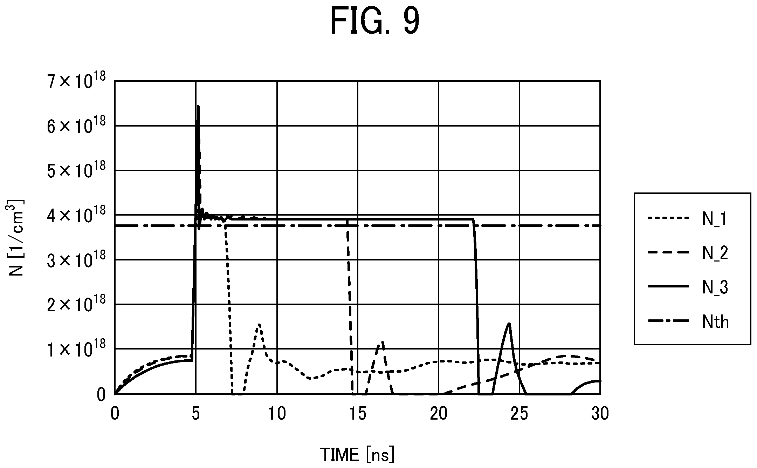

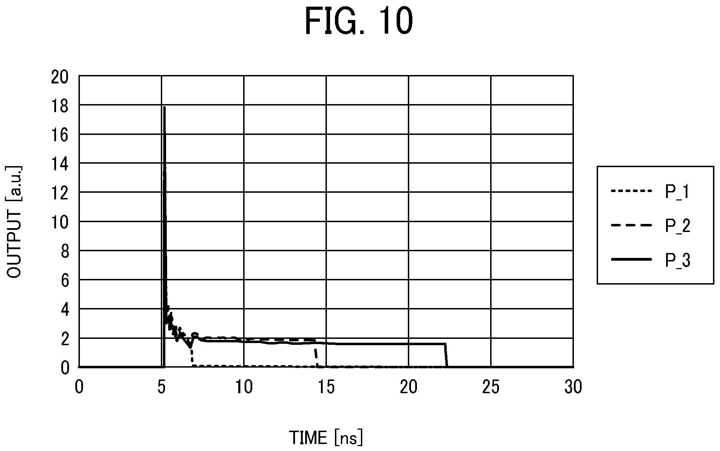

Simulation results according to the reference example are described. For the reference example, a simulation was performed with inputs of the current monitor waveforms presented in FIGS. 5A, 5B, and 5C while the optical confinement factor $\Gamma_r$ in the lateral direction was 1. FIG. 9 presents simulation results for the carrier density N and the threshold carrier density $N_{th}$. FIG. 10 presents simulation results for the optical outputs.

As presented in FIGS. 9 and 10, at the time point of about 5 ns at which the pulse current is injected, the carrier density N exceeds the threshold carrier density $N_{th}$ immediately thereafter, and an optical pulse caused by the relaxation oscillation is output. After that, an equilibrium state is established with constant tail light output. As described above, in the simulation, results closely resembling the actual measurement results presented in FIGS. 5A, 5B, and 5C have been obtained.

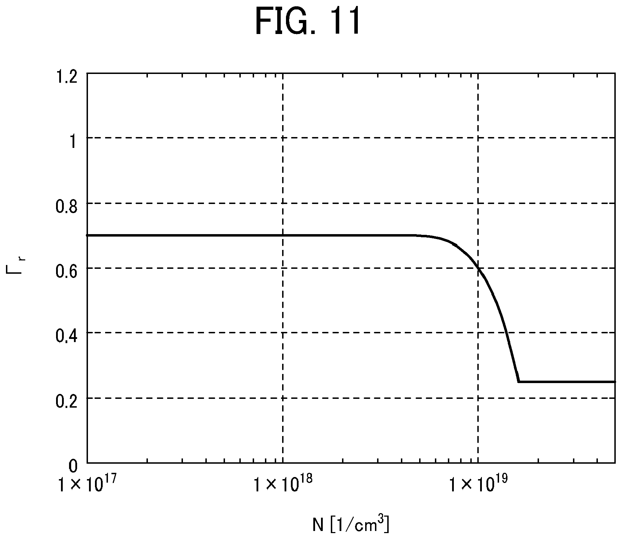

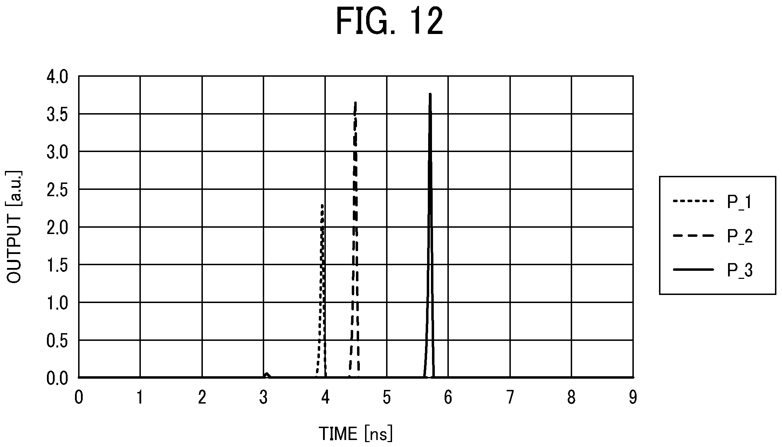

Simulation results according to the first embodiment are described below. For the first embodiment, a simulation was performed with inputs of the current monitor waveforms presented in FIGS. 6A, 6B, and 6C while the optical confinement factor $\Gamma_r$ in the lateral direction was less than 1 and the optical confinement factor $\Gamma_r$ in the lateral direction was a function that decreased as the carrier density N increased. The lateral optical confinement factor $\Gamma_r$ was defined as the above function to incorporate the effects of refractive index change due to the carrier plasma effect. FIG. 11 is a graph presenting the function according to an embodiment of the present disclosure. FIG. 12 is a graph presenting simulation results for the optical outputs.

As presented in FIG. 12, an optical pulse output is achieved when the pulse current injection ceases. As described above, in the simulation, results closely resembling the actual measurement results presented in FIGS. 6A, 6B, and 6C have been obtained.

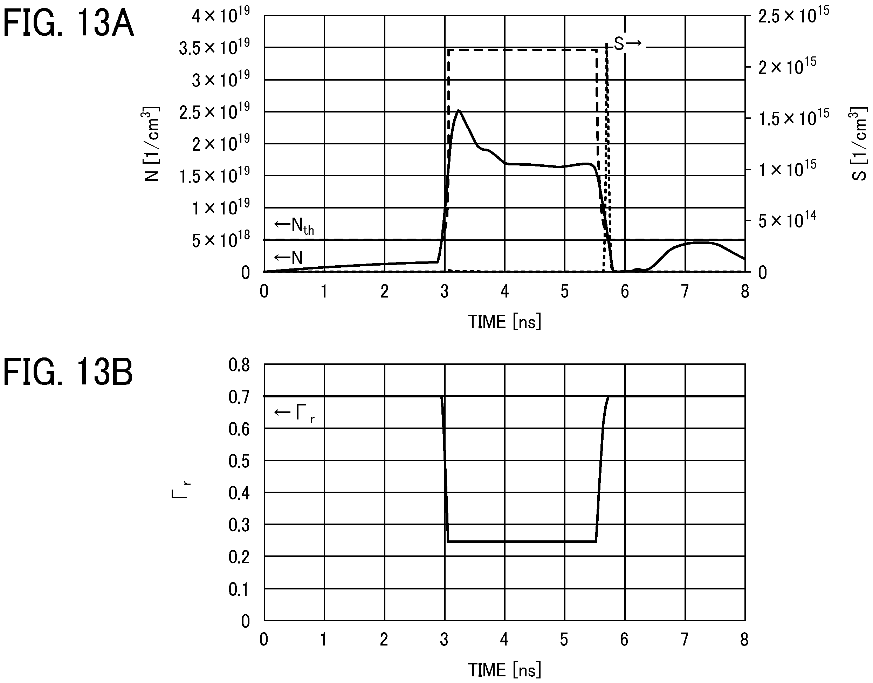

To analyze the results in detail, FIGS. 13A and 13B present simulation results of the carrier density N, the threshold carrier density $N_{th}$, the photon density S, and the optical confinement factor $\Gamma_r$ in the lateral direction under the condition of the pulse width being 2.5 ns. FIG. 13A presents simulation results of the carrier density N, the threshold carrier density $N_{th}$, and the photon density S. FIG. 13B presents simulation results of the optical confinement factor $\Gamma_r$ in the lateral direction.

Since the optical confinement factor $\Gamma_r$ in the lateral direction is the function of the carrier density N, the optical confinement factor $\Gamma_r$ in the lateral direction decreases in a range from 3 ns to 5.5 ns in which the pulse current is injected.

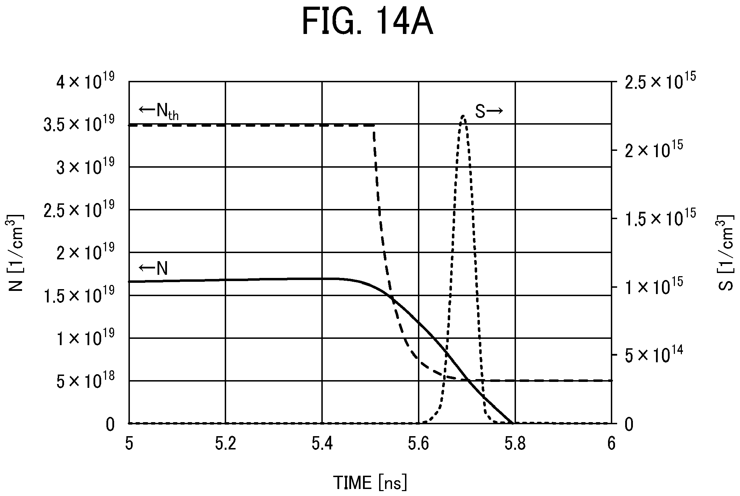

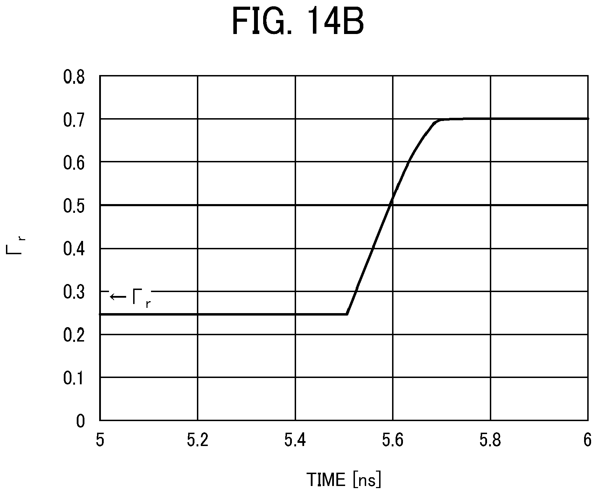

Within this range, the threshold carrier density $N_{th}$ increases along with a decrease in the optical confinement factor $\Gamma_r$ in the lateral direction, and $N < N_{th}$ is established. Hence induced emission is less likely to occur, and the photon density S does not increase. When the injection of the pulse current starts decreasing at the time point of about 5.5 ns, the optical confinement factor $\Gamma_r$ in the lateral direction increases again, and in the process, the photon density S appears in a pulse form. FIGS. 14A and 14B are graphs in which the time axis in the range from 5 ns to 6 ns in FIGS. 13A and 13B is expanded.

When the injection of the pulse current starts decreasing at the time point of about 5.5 ns, the carrier density N starts decreasing. At the same time, the optical confinement factor $\Gamma_r$ in the lateral direction increases, and the threshold carrier density $N_{th}$ decreases. Since the threshold carrier density $N_{th}$ decreases faster than the carrier density N, a period where $N > N_{th}$ occurs during the decrease in the carrier density N. During this period, the photon density S first increases due to spontaneous emission, and when the photon density S increases by a certain degree, induced emission becomes dominant, and the photon density S rapidly increases. At the same time, the carrier density N rapidly decreases, and when $N < N_{th}$ is established again, the photon density rapidly decreases.

As described above, the phenomenon in which the optical pulse is output when the injection of the pulse current is stopped as a trigger can be reproduced by the simulation.

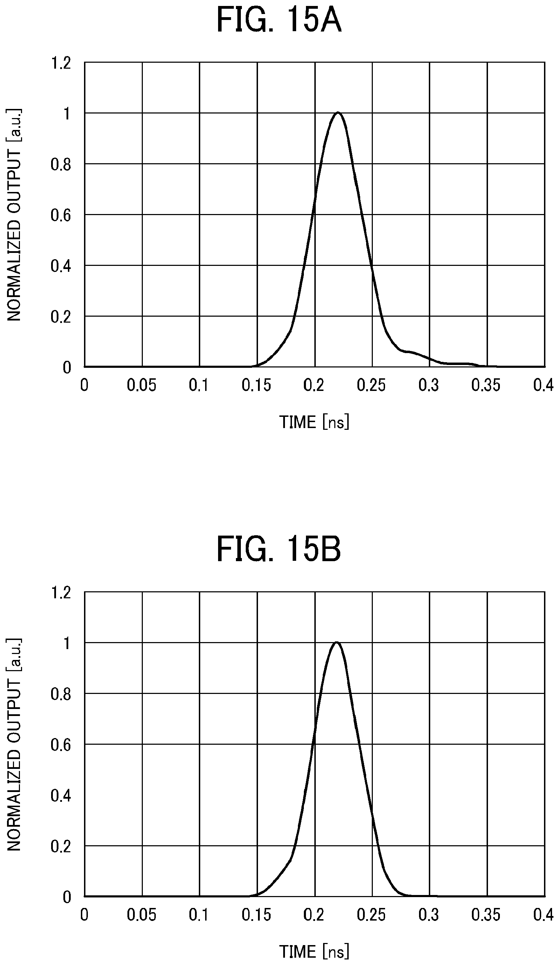

The rise time of the optical pulse decreases as the threshold carrier density $N_{th}$ decreases faster than the carrier lifetime. In other words, based on Equation (7), the rise time shortens as the lateral optical confinement factor $\Gamma_r$ increases more rapidly. The attenuation time of the optical pulse depends on the photon lifetime. FIGS. 15A and 15B are graphs presenting actual measurement results and simulation results of optical pulses according to an embodiment of the present disclosure. FIG. 15A presents the actual measurement results. FIG. 15B presents the simulation results.

In the present specification, the optical pulse width is defined as a time width of $1/e^2$ of its peak value. The obtained optical pulse width is 86 ps in the actual measurement result in FIG. 15A, and is 81 ps in the simulation result in FIG. 15B. In this case, e is a natural logarithm. With this model, the width of the optical pulse is shorter than the pulse current to be injected and can be decreased without being limited by the time width of the pulse current to be injected.

Table 1 presents the full width at half maximum (FWHM) and the optical pulse width (or the time width of $1/e^2$ of the peak value) in the actual measurement results in FIGS. 6A to 6C. In any case, FWHMs from 40 ps to 60 ps and optical pulse widths from 80 ps to 110 ps were obtained. The ratio of the optical pulse width to the full width at half maximum (i.e., optical pulse width/full width at half maximum) was from about 1.7 to about 1.8. Based on the definition of the Gaussian function formula, the ratio of the optical pulse width to the full width at half maximum is 1.70, and hence the optical pulse according to the present embodiment has a waveform close to the Gaussian function. In contrast, regarding the actual measurement results of the reference example (FIGS. 5A to 5C), since the constant tail light is output after the pulsed light, the optical pulse width is not $1/e^2$ or less of the peak value until the current injection is stopped. In other words, since the optical pulse width (or the time width of $1/e^2$ of the peak value) depends on the width of the pulse current, it is difficult to achieve an optical pulse width on the order of picoseconds.

[Table 1]

|  | FIG. 6A | FIG. 6B | FIG. 6C |
|---|---|---|---|
| FWHM (ps) | 57.8 | 49.2 | 50.0 |
| $1/e^2$ (ps) | 103.9 | 85.2 | 85.9 |
| Ratio | 1.80 | 1.73 | 1.72 |

In the present embodiment, a continuous optical pulse train is less likely to be generated after the optical pulse output is generated.

This is because the injection of the pulse current decreases when the optical pulse is generated, and the relaxation oscillation is less likely to be generated.

Moreover, tail light is less likely to be generated after the optical pulse output is generated. This is because the injection of the pulse current decreases after the optical pulse is generated, and the carrier density is less likely to increase.

Furthermore, since the optical pulse is emitted immediately after the injection of the pulse current is stopped, the output timing of the pulsed light can be controlled as desired.

Furthermore, the width of the pulsed light produced according to the first embodiment is shorter than the width of the injected pulse current.

Even when the current is increased, there is no need to shorten the pulse current width, and hence the surface-emitting laser is less likely to be influenced by parasitic inductance.

Multiple surface-emitting lasers 100 according to the first embodiment may be arranged in parallel to form a surface-emitting laser array, and optical pulses may be simultaneously output. Thus, a larger optical peak output can be achieved. The current injected into the surface-emitting laser array is greater than that into one surface-emitting laser 100. The width of the optical pulse output from the surface-emitting laser 100 is narrower than the width of the injected pulse current, allowing for an output with a narrower optical pulse width.

The pulse width of the light output from the surface-emitting laser 100 according to the first embodiment is not limited; however, the pulse width is, for example, 1 ns or less, preferably 500 ps or less, and more preferably 100 ps or less.

In the first embodiment, the oxidized region 151, located at a position 3 μm separated outward from the inner edge of the inner region 154, i.e., from the tip portion of the boundary between the non-oxidized region 152 and the oxidized region 151, preferably has a thickness no more than twice that of the non-oxidized region 152. For example, when the thickness of the non-oxidized region 152 is 31 nm, the thickness at the position 3 μm separated outward from the inner edge of the inner region 154 is preferably 62 nm or less, and may be 54 nm. When the distance (oxidation distance) from the side surface of the mesa 180 to the inner edge of the oxidized region 151 is in a range from 8 μm to 11 μm, the distance of 3 μm corresponds to 28% to 38% of the oxidation distance. When the thickness of the oxidized region 951 and the thickness of the non-oxidized region 952 were measured at the position 3 μm separated outward from the inner edge of the oxidized region 951 in the actual measurement of the above-described reference example, the thickness of the oxidized region 951 was 79 nm, and the thickness of the non-oxidized region 952 was 31 nm. The thickness of the oxidized region 951 was 2.55 times the thickness of the non-oxidized region 952. As a result of the comparative evaluation of various elements having oxidized confinement structures, the inventors have found that the optical confinement factor $\Gamma_r$ in the lateral direction decreases when the ratio is 2 or less, and short-pulse light with a high output and no tailing is likely to be obtained.

Results of an optical mode simulation using actual measurement values of the first embodiment and the reference example are described. In the optical mode simulation, the refractive index of each region is set in a rotationally symmetrical multilayer structure model to calculate the electric field intensity distribution of the natural mode. Calculation was performed in the present optical mode simulation under a cold cavity condition not including the influence of heat generated by energization.

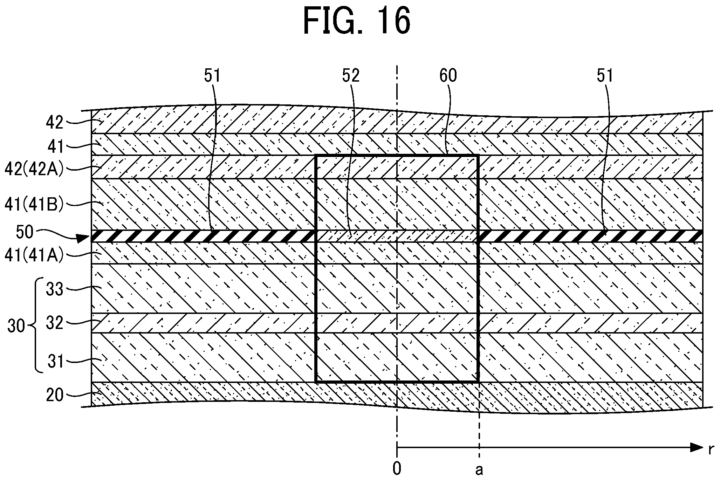

FIG. 16 is a cross-sectional view of a first model used for a simulation. The first model includes an n-type DBR 20, an active layer region 30, and a p-type DBR 40. The active layer region 30 is on the n-type DBR 20, and the p-type DBR 40 is on the active layer region 30.

The active layer region 30 includes a lower spacer layer 31, a quantum well layer 32, and an upper spacer layer 33. The lower spacer layer 31 is on the n-type DBR 20, the quantum well layer 32 is on the lower spacer layer 31, and the upper spacer layer 33 is on the quantum well layer 32.

The p-type DBR 40 includes multiple low refractive index layers 41, multiple high refractive index layers 42, and an oxidized confinement layer 50. The lowermost low refractive index layer 41 (41A) is on the upper spacer layer 33.

The oxidized confinement layer 50 is on the low refractive index layer 41A. The oxidized confinement layer 50 includes an oxidized region 51 and a non-oxidized region 52 in a plane perpendicular to the emission direction of light. The oxidized region 51 has an annular planar shape and surrounds the non-oxidized region 52. The non-oxidized region 52 contains AIAs. The low refractive index layer 41 (41B) that is the second from the lower side is on the oxidized confinement layer 50. On the low refractive index layer 41B, high refractive index layers 42 and other low refractive index layers 41 are alternately stacked. In this model, the thickness of the oxidized region 51 is constant, and the oxidized region 51 does not have a tapered shape.

The optical thickness of the active layer region 30 is an oscillation wavelength λ. The sum of the thicknesses of the low refractive index layer 41A, the oxidized confinement layer 50, and the low refractive index layer 41B is 3λ/4. The thickness of the high refractive index layer 42A is λ/4.

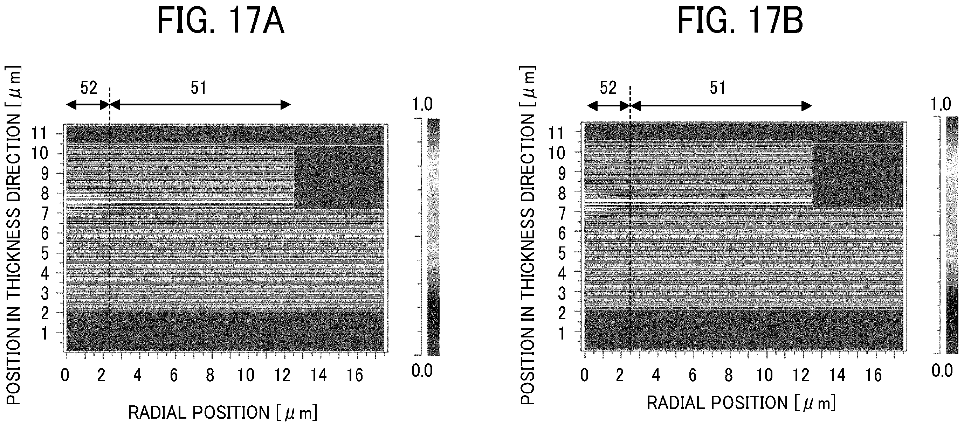

The relation between the optical confinement factor and the thickness of the oxidized confinement layer 50 is described first. FIGS. 17A and 17B are graphs each illustrating a cross-sectional profile of an electric-field intensity distribution of a fundamental mode in the structure in which the diameter of a non-oxidized region is 5 μm. FIG. 17A illustrates a cross-sectional profile when the thickness of the oxidized confinement layer 50 is 20 nm. FIG. 17B illustrates a cross-sectional profile when the thickness of the oxidized confinement layer 50 is 40 nm. The optical confinement factor can be estimated as a ratio of the electric field intensity in the oxidized confinement layer 50 to the sum of the electric field intensities in the entire region. In the structure in which the thickness of the oxidized confinement layer 50 is 20 nm, the electric field intensity distribution expands in the lateral direction and the proportion of the electric field intensity distribution present outside the non-oxidized region 52 is large compared to the structure in which the thickness of the oxidized confinement layer 50 is 40 nm, and thus the optical confinement factor is small.

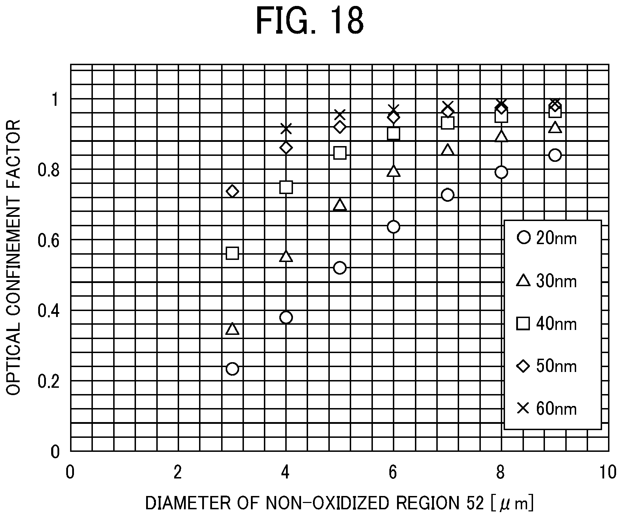

The following describes the relation among the optical confinement factor, the thickness of the oxidized confinement layer 50, and the diameter of the non-oxidized region 52. FIG. 18 is a graph presenting the calculated relation between the optical confinement factor, the thickness of an oxidized confinement layer, and the diameter of a non-oxidized region. In FIG. 18, the horizontal axis indicates the diameter of the non-oxidized region 52, and the vertical axis indicates the optical confinement factor. FIG. 18 presents the results of optical confinement factors calculated when the thickness of the oxidized confinement layer 50 is in a range from 20 nm to 60 nm and the diameter of the non-oxidized region 52 is in a range from 3 μm to 9 μm. In a range in which the thickness of the oxidized confinement layer 50 is 40 nm or more and the diameter of the non-oxidized region 52 is 5 μm or more, the optical confinement factor tends to be saturated to about 0.9 or more. This trend is evident when the optical confinement factor is below the saturation value. As illustrated in FIG. 17A, there's a notable expansion in the lateral distribution of electric field intensity, and a significant portion of this intensity is found outside the oxidized region.

The calculation results relating to the relation among the thickness of the oxidized confinement layer 50, the diameter of the non-oxidized region 52, and the optical confinement factor have been described. The following describes the calculation results of an electric field intensity distribution when the refractive index near the tip end of the oxidized region 51 is intentionally decreased.

A region 60 whose refractive index is to be decreased was a region having a thickness of about 200 nm corresponding to the lowermost one pair of the p-type DBRs 40 above the non-oxidized region 52 (AlAs layer) and was a region having a thickness of about 300 nm including the upper spacer layer 33, the quantum well layer 32, and the lower spacer layer 31 below the non-oxidized region 52 (AlAs layer). The reason the lower region is made larger than the upper region is that the lower region is closer to the active layer region 30, and a larger area with a high carrier density is anticipated. The radial region where the refractive index is changed was set to the same as the non-oxidized region 52.

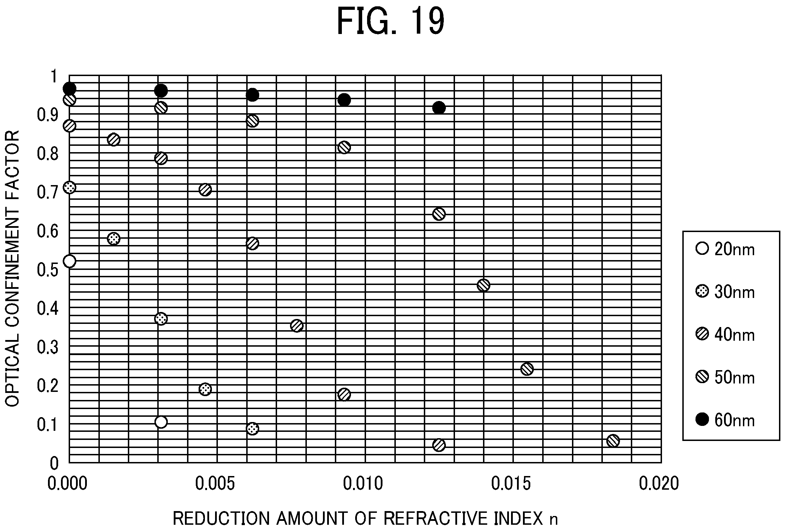

FIG. 19 is a graph presenting the calculated relation between the thickness of an oxidized confinement layer and the optical confinement factor for the first model. The thicknesses of the oxidized confinement layer 50 included four levels in a range from 30 nm to 60 nm, and the amount by which the refractive index n was decreased (the amount by which the refractive index n was decreased) was in a range from 0 to about 0.02. In FIG. 19, the horizontal axis indicates the amount of decrease in the refractive index n, and the vertical axis indicates the optical confinement factor. The larger the amount by which the refractive index n is decreased, the lower the refractive index in the region 60. It is found that, in the case where the thickness of the oxidized confinement layer 50 is 60 nm, the optical confinement factor is hardly decreased even when the refractive index is markedly decreased; however, as the thickness of the oxidized confinement layer 50 is decreased, the optical confinement factor is likely to be decreased even when the amount of decrease in the refractive index n is small.

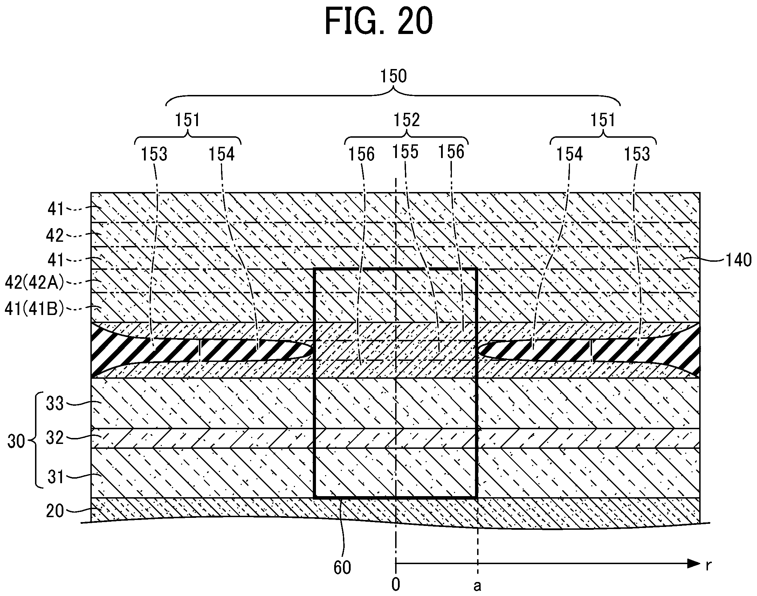

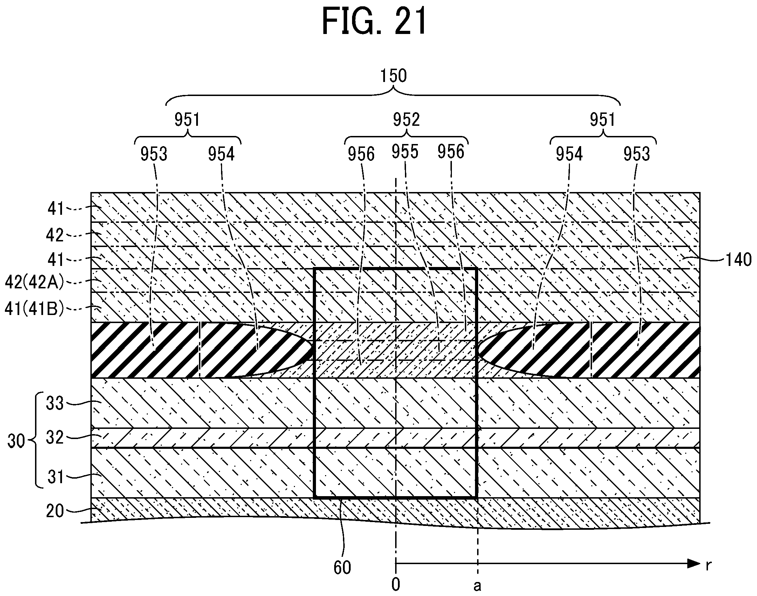

Results of simulations using a model closer to that of the first embodiment or the reference example are described below. FIG. 20 illustrates a second model used for the simulation. FIG. 21 illustrates a third model used for the simulation. The second model is a model closer to that of the first embodiment. The third model is a model closer to that of the reference example. The electric-field intensity distribution when the refractive index near the tip end of the oxidized region was intentionally decreased was calculated for the second model and the third model, similarly to the first model.

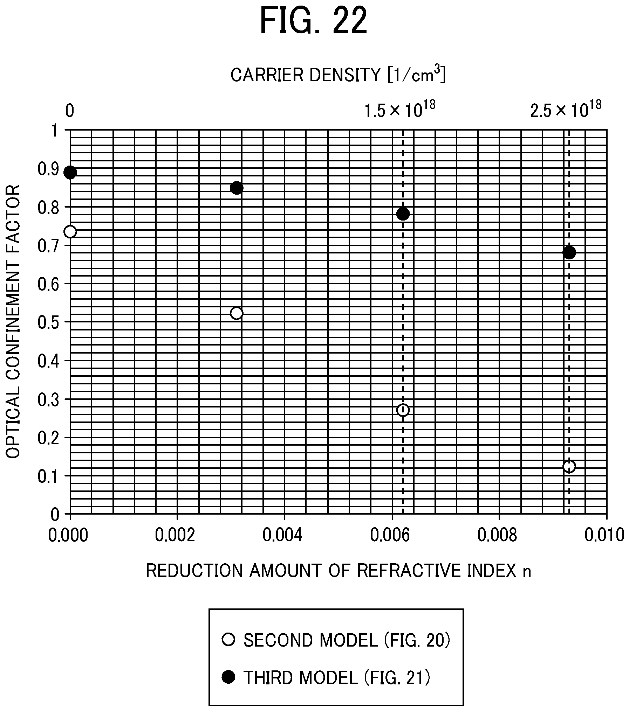

FIG. 22 is a graph presenting calculation results of the relation between the amount of decrease in refractive index and the optical confinement factor for the second model and the third model. The amount of decrease in the refractive index n was in a range from 0 to about 0.01. The horizontal axis on the lower side in FIG. 22 indicates the amount of decrease in the refractive index n, and the vertical axis indicates the optical confinement factor. As presented in FIG. 22, in the second model (FIG. 20) imitating the first embodiment, when the refractive index is decreased to about 0.01, the optical confinement factor, which was 0.7 before the refractive index was decreased, is decreased to 0.1.

In contrast, in the third model (FIG. 21) imitating the reference example, when the refractive index is decreased to about 0.01, the optical confinement factor, which was 0.9 before the decrease, is decreased to 0.7. Thus, in the second model, the amount of change in the optical confinement factor with respect to the decrease in the refractive index is large, and hence a pulsed-light output due to a rapid change in the optical confinement factor can be provided.

As indicated by the upper horizontal axis in FIG. 22, when converted from Equation (3) for estimating the carrier plasma effect, an amount of decrease in the refractive index n being 0.006 corresponds to a carrier density N of $1.5 \times 10^{18}$ (1/cm$^3$), and an amount of decrease in the refractive index n being 0.010 corresponds to a carrier density N of $2.5 \times 10^{18}$ (1/cm$^3$). FIG. 11 presents a function of decreasing the optical confinement factor in a range of the carrier density N from $5.0 \times 10^{18}$ (1/cm$^3$) to $1.5 \times 10^{19}$ (1/cm$^3$). The range of the carrier density N differs between FIG. 11 and FIG. 22 because the carrier density in the quantum well layer is targeted in FIG. 11 whereas the target of changing the refractive index is a wide region including the upper and lower portions of the quantum well layer in FIG. 22. The carrier density in the wide region above and below the quantum well layer is expected to expand due to, for example, diffusion in the lateral direction. When it is assumed that the carrier density of the region with the decreased refractive index is smaller than the carrier density in the quantum well layer by about one digit, the range of the carrier density presented in FIG. 11 can be considered equivalent to the range of the carrier density presented in FIG. 22.

The following describes simulation results of the relation between the thickness of the oxidized region at a position 3 μm from the boundary between the non-oxidized region 52 and the oxidized region 51 and the optical confinement factor according to the first embodiment.

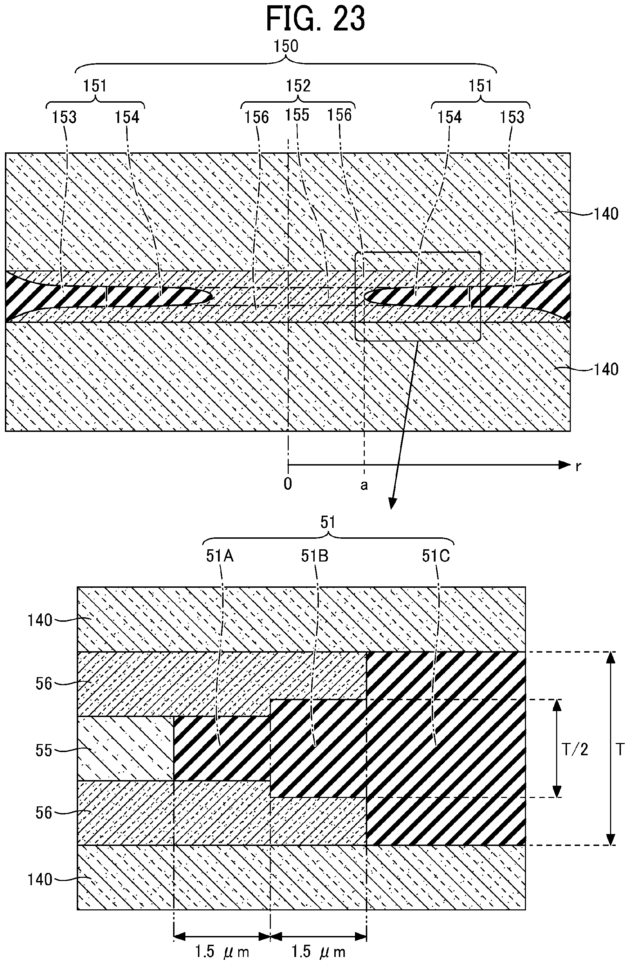

FIG. 23 is a cross-sectional view of a fourth model used for the simulation. In the fourth model, the oxidized region 51 includes a first region 51A, a second region 51B, and a third region 51C. The planar shapes of the first region 51A, the second region 51B, and the third region 51C are annular. The first region 51A is located outside the non-oxidized region 52, the second region 51B is located outside the first region 51A, and the third region 51C is located outside the second region 51B in the lateral direction. The non-oxidized region 52 includes an AIAs layer 55 and two AlGaAs layers 56 that sandwich the AIAs layer 55 in the vertical direction.

The thickness of the AIAs layer 55 is 30 nm. The thickness of the first region 51A is 30 $\mu$m, the thickness of the third region 51C is T ($\mu$m), and the thickness of the second region 51B is T/2 ($\mu$m). The widths of the first region 51A and the second region 51B in the radial direction are both 1.5 $\mu$m.

The thickness of the oxidized region 51 at a position 3 $\mu$m separated outward from the boundary between the non-oxidized region 52 and the oxidized region 51, that is, from a boundary 59 between the non-oxidized region 52 and the first region 51A, is the thickness of the third region 51C.

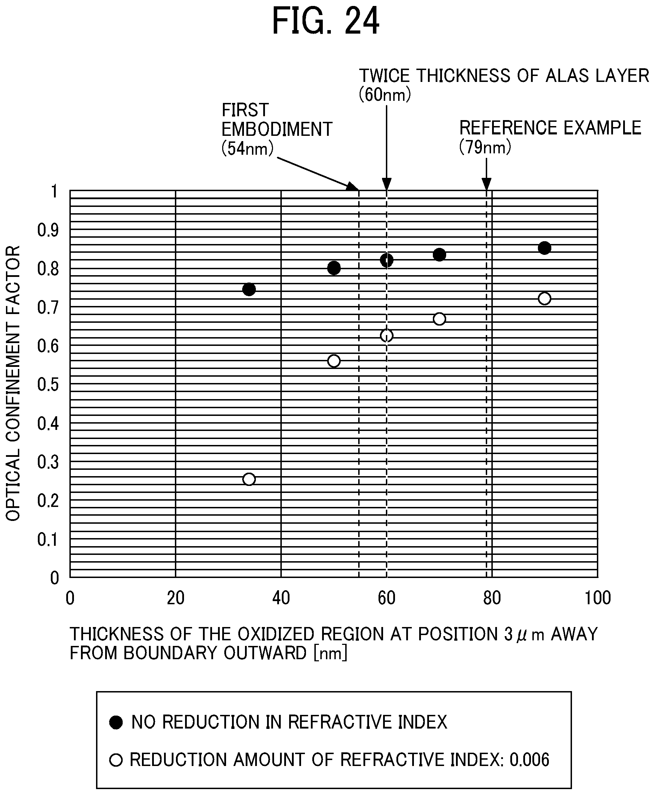

FIG. 24 is a graph presenting the calculated relation between the thickness of an oxidized region at the position 3 $\mu$m separated outward from the boundary and the optical confinement factor for the fourth model. FIG. 24 presents calculation results when the refractive index does not decrease and calculation results when the refractive index decreases by 0.006. In FIG. 24, the horizontal axis indicates the thickness of the oxidized region 51 at the position 3 $\mu$m separated outward from the boundary 59, and the vertical axis indicates the optical confinement factor.

As presented in FIG. 24, it is found that when the thickness of the oxidized region 51 at the position 3 $\mu$m separated outward from the boundary 59 is 60 nm or less, the amount of decrease in optical confinement factor is large compared to a case where the thickness is more than 60 nm. In other words, it is found that when the thickness of the oxidized region 51 at the position 3 $\mu$m separated outward from the boundary 59 is twice or less the thickness of the AIAs layer 55, the amount of decrease in optical confinement factor is large compared to a case where the thickness is more than twice the thickness of the AIAs layer 55. Thus, in the region in which the thickness of the oxidized region 51 at the position 3 $\mu$m separated outward from the boundary 59 is twice or less the thickness of the AIAs layer 55, the change in optical confinement factor with respect to the amount of change in refractive index is large, and hence the pulsed-light output due to a rapid change in optical confinement factor according to the first embodiment can be provided. The actual measurement value of the thickness of the oxidized region 151 at the position 3 $\mu$m separated outward from the inner edge of the inner region 154 of a sample fabricated according to the first embodiment was 54 nm. The actual measurement value of the thickness of the oxidized region 951 at the position 3 $\mu$m separated outward from the inner edge of the oxidized region 951 of a sample fabricated according to the reference example was 79 nm.

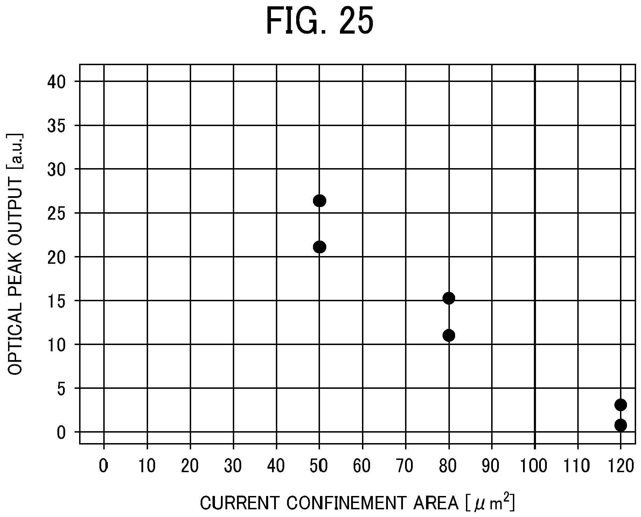

The area (or current confinement area) of the non-oxidized region 152 in plan view is desirably 120 $\mu$m$^2$ or less. Through a comparative evaluation of various elements of the non-oxidized region 152, the inventors have found that the likelihood of optical pulses being emitted immediately after the injection of the pulse current is stopped decreases when the area of the non-oxidized region 152 exceeds 120 $\mu$m$^2$. It was also found that pulsed light with a high peak output is more likely to be obtained as the non-oxidized region 152 is smaller. FIG. 25 is a graph presenting measurement results of a peak optical output for a sample in which the area of a non-oxidized region is in a range from 50 $\mu$m$^2$ to 120 $\mu$m$^2$.

Second Embodiment

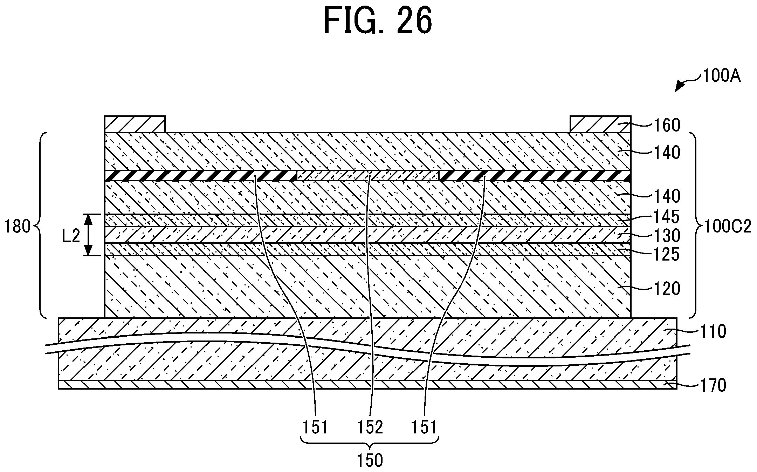

The second embodiment of the present disclosure is described below. The second embodiment relates to a surface-emitting laser. FIG. 26 is a cross-sectional view of a surface-emitting laser 100A according to the second embodiment. In the second embodiment, substantially like reference signs are given to elements similar to those of the first embodiment, and overlapping description may be omitted.

The surface-emitting laser 100A includes an n-type GaAs substrate 110, an n-type DBR 120, a first spacer layer 125, an active layer 130, a second spacer layer 145, a p-type DBR 140, an oxidized confinement layer 150, an upper electrode 160, and a lower electrode 170.

The first spacer layer 125 is on the n-type DBR 120. The active layer 130 is on the first spacer layer 125. The second spacer layer 145 is on the active layer 130. Examples of material forming the first spacer layer 125 and the second spacer layer 145 include semiconducting materials such as $Al_{1-X}Ga_XAs$. However, no limitation is indicated thereby.

In the second embodiment, the n-type DBR 120, the first spacer layer 125, the active layer 130, the second spacer layer 145, and the p-type DBR 140 form a resonator 100C2.

In the current injection period, carriers (electrons on the n-side and holes on the p-side) injected into the surface-emitting laser 100A are accumulated in the first spacer layer 125 and the second spacer layer 145. In the current decrease period, the carriers accumulated in the first spacer layer 125 and the second spacer layer 145 are supplied to the active layer 130.

A resonator length L2 of the resonator 100C2 corresponds to the total optical thickness of the first spacer layer 125, the active layer 130, and the second spacer layer 145. In the second embodiment, the resonator length L2 is 1.5 times the oscillation wavelength $\lambda$ or more. In other words, the relation between the resonator length L2 and the oscillation light wavelength $\lambda$ is defined in Equation (1) for cases where n is 3 or greater. The resonator length L2 corresponds to L in Equation (1).

The resonator length L2 increases as the thicknesses of the first spacer layer 125 and the second spacer layer 145 increase. For example, in the current injection period, the first spacer layer 125 and the second spacer layer 145 serve as a carrier accumulation layer (or a layer to accumulate carriers). With an increase in the thicknesses of the first spacer layer 125 and the second spacer layer 145, the number of carriers to be accumulated increases. This allows for an increase in the density of the carriers supplied to the active layer 130 during the current decrease period, enhancing the peak output of the pulsed light.

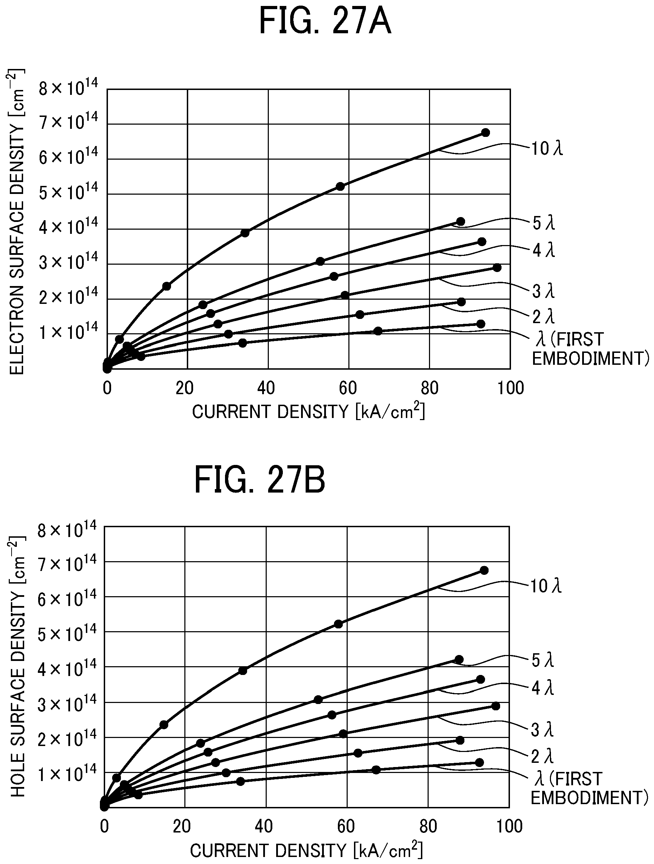

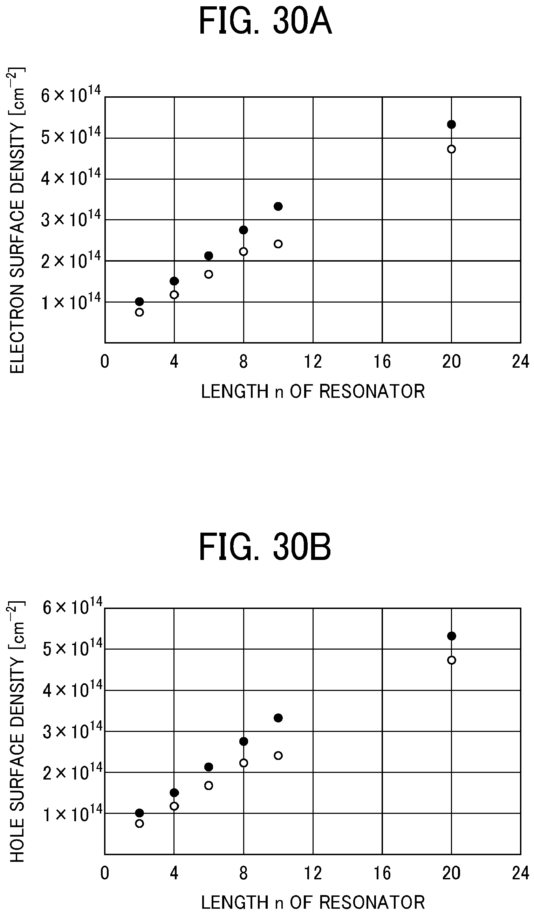

A surface-emitting laser 100A according to the second embodiment is described below with reference to FIGS. 27A, 27B to 30A, 30B. Examples of characteristics are described for the surface-emitting laser 100A when its resonator length L2 is twice (n = 4, L2 = 2λ), three times (n = 6, L2 = 3λ), four times (n = 8, L2 = 4λ), five times (n = 10, L2 = 5λ), ten times (n = 20, L2 = 10λ), twenty times (n = 40, L2 = 20λ), and thirty times (n = 60, L2 = 30λ) the oscillation wavelength λ. To more clearly demonstrate the characteristics of the surface-emitting laser 100A, the characteristics of another surface-emitting laser with a resonator length L1 equal to the oscillation wavelength λ (n = 2, L1 = λ) are sometimes presented as a comparative example. The resonator length L1 and the resonator length L2 serve as L in Equation (1).

The relation between the density of current injected into the resonator 100C2 and the carrier surface density within the resonator 100C2 in the surface-emitting laser 100A according to the second embodiment is described with reference to FIGS. 27A and 27B. FIGS. 27A and 27B are graphs each presenting simulation results. The horizontal axis indicates the current density injected into the resonator 100C2, and the vertical axis indicates the electron surface density of the first spacer layer 125. FIG. 27B is a graph presenting simulation results. The horizontal axis indicates the current density injected into the resonator 100C2, and the vertical axis indicates the hole surface density of the second spacer layer 145. In the simulation, the first spacer layer 125 and the second spacer layer 145 were set to $Al_{0.16}Ga_{0.84}As$. The low refractive index layer of the n-type DBR 120 was set to n-$Al_{0.93}Ga_{0.07}As$, and the low refractive index layer of the p-type DBR 140 was set to $pAl_{0.93}Ga_{0.07}As$. The wavelength of the oscillation light emitted or oscillated by the active layer 130 was set to 940 nm. In the present disclosure, the electron surface density of the first spacer layer 125 and the hole surface density of the second spacer layer 145 are sometimes collectively referred to as the carrier surface density of the resonator 100C2.

As illustrated in FIGS. 27A and 27B, the carrier surface density of the resonator 100C2 in the second embodiment is higher than that of the resonator 100C in the first embodiment. In the second embodiment, with an increase in the resonator length L2, an increase in the carrier surface density of the resonator 100C2 is observed. The increase in the carrier surface density of the resonator 100C2 leads to more carriers for the oscillation of pulsed light in the active layer 130. This results in higher output pulsed light.

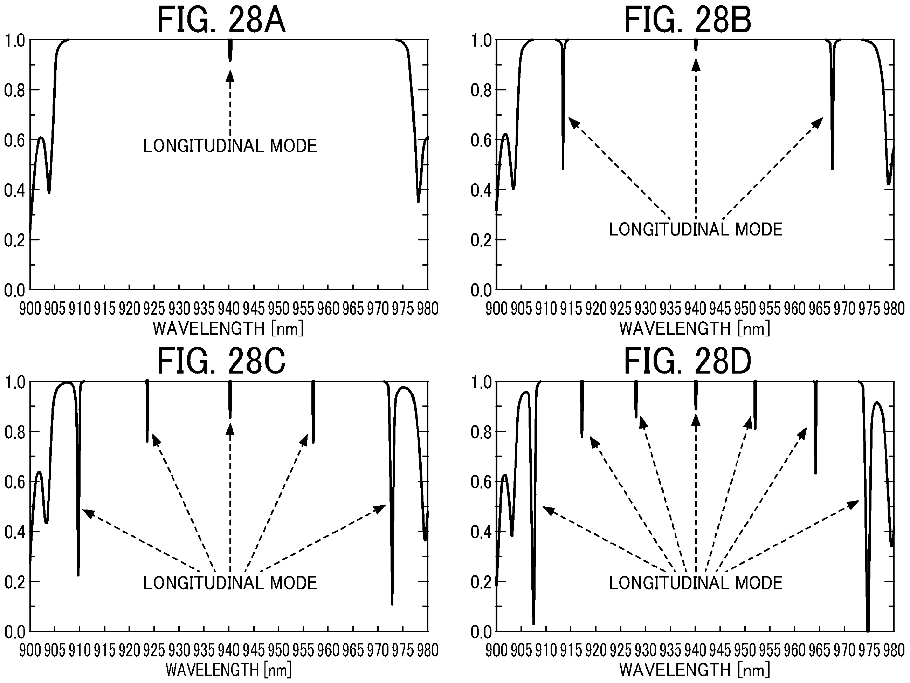

As illustrated in FIG. 28, as the resonator length L2 increases, the number of longitudinal modes of the resonator increases. With the resonator length L1 (L1 = λ), a single longitudinal mode occurs, producing one pulsed beam at a wavelength of 940 nm. In contrast, with the resonator length L2 at 10λ, three longitudinal modes with resonance wavelengths of 917 nm, 940 nm, and 967 nm are generated as illustrated in FIG. 28B. In this case, the interval between the wavelengths of the longitudinal modes is about 25 nm.

When the resonator length L2 of the resonator 100C2 increases to reach 20λ, five longitudinal modes with resonance wavelengths of 909 nm, 923 nm, 940 nm, 957 nm, and 972 nm are generated as illustrated in FIG. 28C. In this case, the interval between the wavelengths of the longitudinal modes is about 16 nm. In other words, the interval between the wavelengths of the longitudinal modes for the resonator length L2 of 20λ is smaller than that for the resonator length L2 of 10λ.

When the resonator length L2 of the resonator 100C2 increases to reach 30λ, seven longitudinal modes with resonance wavelengths of 907 nm, 917 nm, 928 nm, 940 nm, 952 nm, 964 nm, and 974 nm are generated as illustrated in FIG. 28D. In this case, the interval between the wavelengths of the longitudinal modes is about 11 nm, which is much smaller than the interval for the resonator length L2 of 10λ and the interval for the resonator L2 of 20λ.

As described above, when the interval between the wavelengths of the longitudinal modes narrows to a level equivalent to the gain spectrum width of the active layer 130 with an increase in the resonator length L2, emission recombination occurs between multiple longitudinal modes, potentially reducing the number of carriers consumed by a single longitudinal mode. Further, differences in oscillation timing occur between different longitudinal modes. Such energy dispersion and time dispersion of oscillation timing between the longitudinal modes lead to a reduction in the peak power of pulsed light at a desired wavelength. Given that the gain spectrum width of the active layer 130 is about 20 nm, a reduction in the peak power of each pulsed light may occur as the interval between the longitudinal modes narrows to about 10 nm. In view of the above, the resonator length L2 is preferably in a range from 1.5λ to 30λ.

In the surface-emitting laser 100A that emits, or oscillates pulsed light in a shorter wavelength range, the relative difference in bandgap energy between the quantum well layers forming the active layer 130 and the first spacer layer 125 (or the second spacer layer 145) decreases. With a reduction in the band discontinuity between the active layer 130 and the first spacer layer 125 (or the second spacer layer 145), the capacity for carriers accumulation in the first spacer layer 125 (or the second spacer layer 145) is small.

In the resonator length 100C2 of the surface-emitting laser 100A, the thicknesses of the first spacer layer 125 and the second spacer layer 145 are increased to increase the resonator length L2. As a result, an increased number of carriers can be accumulated in the first spacer layer 125 and the second spacer layer 145, leading to higher output of pulsed light.

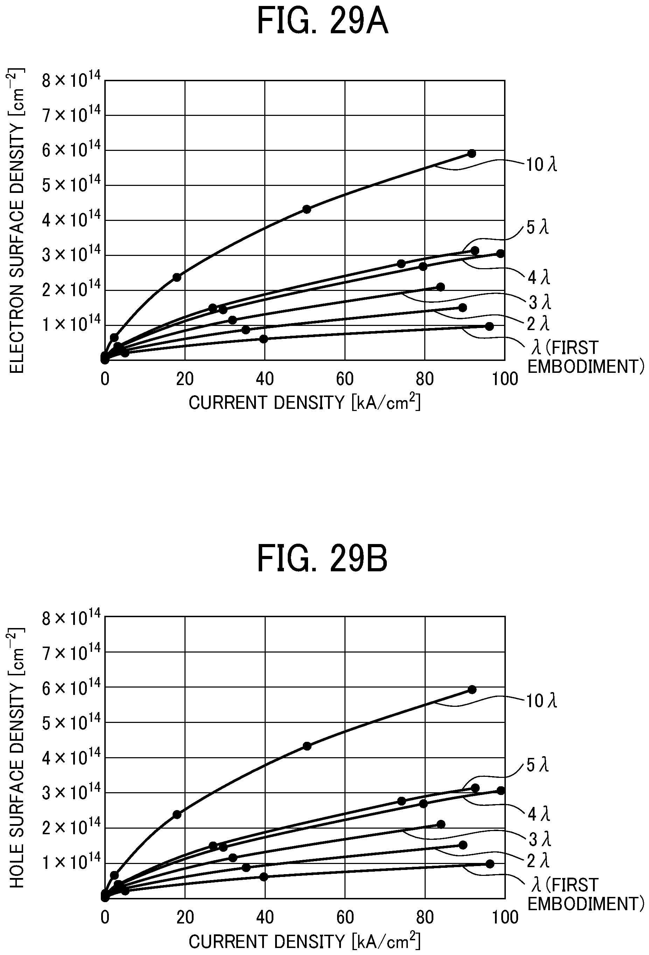

FIGS. 29A and 29B are graphs each presenting the relation between the current density injected into the resonator 100C2 and its carrier surface density within the resonator 100C2 in the surface-emitting laser 100A at an oscillation wavelength of 780 nm for pulsed light. FIG. 29A is a graph presenting simulation results. The horizontal axis indicates the current density injected into the resonator 100C2, and the vertical axis indicates the electron surface density of the first spacer layer 125. FIG. 29B is a graph presenting simulation results. The horizontal axis indicates the current density injected into the resonator 100C2, and the vertical axis indicates the hole surface density of the second spacer layer 145. In the simulation, the first spacer layer 125 and the second spacer layer 145 were set to $Al_{0.2}Ga_{0.8}As$. The low refractive index layer of the n-type DBR 120 was set to $n-Al_{0.93}Ga_{0.07}As$, and the low refractive index layer of the p-type DBR 140 was set to $p-Al_{0.93}Ga_{0.07}As$.

As illustrated in FIGS. 29A and 29B, even with an oscillation wavelength of 780 nm, the carrier surface density of the resonator 100C2 in the second embodiment remains higher than that of the resonator 100C in the first embodiment. Further, with an increase in the resonator length L2, an increase in the carrier surface density of the resonator 100C2 is also observed.

FIGS. 30A and 30B are graphs each comparing carrier surface density in the resonator 100C2 between a surface-emitting laser 100A with an oscillation wavelength of 940 nm for pulsed light and a surface-emitting laser 100A with an oscillation wavelength of 780 nm for pulsed light. The variable on the horizontal axis of the graph in FIGS. 30A and 30B is the natural number n in Equation (1). The vertical axis of the graph in FIGS. 30A and 30B represents the carrier surface density in the resonator 100C2. In each surface-emitting laser 100A, the current density injected into the resonator 100C2 was set to 60 kiloamperes per square centimeter ($kA/cm^2$).

As illustrated in FIGS. 30A and 30B, when comparing the cases where the oscillation wavelength of the pulsed light is 780 nm, indicated by white circle plot points, and where the oscillation wavelength of the pulsed light is 940 nm, indicated by black circle plot points, the carrier surface density of the resonator 100C2 is substantially the same. As described above, the surface-emitting laser 100A according to the second embodiment achieves high-output performance of multiple types of pulse beams with different oscillation wavelengths.

The surface-emitting laser has various applications such as light sources used in, for example, distance measuring apparatuses and biometric detectors, each involving different wavelength bands. Further, multiple light-emitting elements that emit beams with different wavelength bands may be used. Higher power output is demanded for the light-emitting elements at the respective wavelengths. The surface-emitting laser 100A achieves higher power output for different wavelengths, making it well-suitable for devices that involve high-power and short-pulse emission characteristics.

Third Embodiment

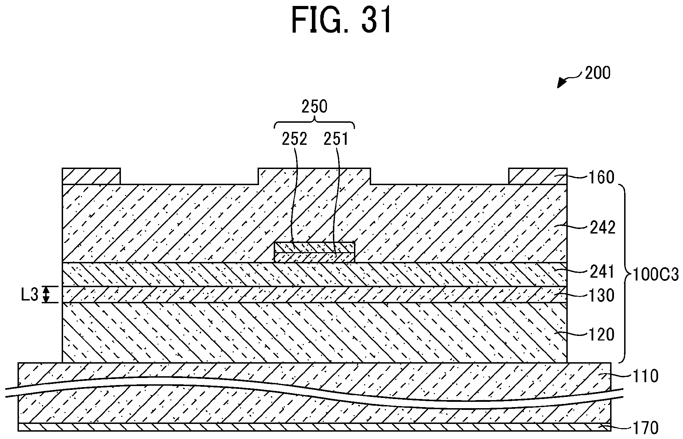

The third embodiment of the present disclosure is described below. The third embodiment relates to a surface emitting laser. FIG. 31 is a cross-sectional view of a surface-emitting laser according to the third embodiment.

The surface-emitting laser 200 according to the third embodiment is, for example, a VCSEL including a current confinement structure by buried tunnel junction (BTJ). The surface-emitting laser 200 includes an n-type GaAs substrate 110, an n-type DBR 120, an active layer 130, a p-type DBR 241, a BTJ region 250, a n-type DBR 242, an upper electrode 160, and a lower electrode 170.

In the surface-emitting laser 200 according to the third embodiment, the n-type DBR 120, the active layer 130, the p-type DBR 241, the BTJ region 250, and the n-type DBR 242 form a resonator 100C3. The cavity length L3 of the resonator 100C3 according to the third embodiment corresponds to the optical thickness between the n-type DBR 120 and the p-type DBR 241. In the third embodiment, the optical thickness of the active layer 130 between the n-type DBR 120 and the p-type DBR 241 corresponds to the cavity length L3. Examples of L in Equation (1) include the resonator length L3 in the third embodiment.

The p-type DBR 241 is on the active layer 130. The p-type DBR 241 is, for example, a semiconducting multilayer reflector consisting of multiple p-type semiconductor films that are multilayered. The BTJ region 250 is on a portion of the p-type DBR 241. The BTJ region 250 includes a p-type layer 251 and an n-type layer 252. The n-type DBR 242 is on the p-type DBR 241 and covers the BTJ region 250. The n-type DBR 242 is, for example, a semiconductor multilayer-film reflecting mirror including multiple n-type semiconductor films stacked on one another. The n-type DBR 242, the p-type DBR 241, the active layer 130, and the n-type DBR 120 include a mesa 280. The BTJ region 250 is located at the center of the mesa 280 in the plane.

The p-type layer 251 is on the p-type DBR 241, and the n-type layer 252 is on the p-type layer 251. The p-type layer 251 contains a p-type impurity at a concentration higher than that of the p-type semiconductor film forming the p-type DBR 241. The n-type layer 252 contains an n-type impurity at a concentration higher than that of the n-type semiconductor film forming the n-type DBR 242. For example, the thickness of the p-type layer 251 is from 5 nm to 20 nm, and the thickness of the n-type layer 252 is from 5 nm to 20 nm. In plan view, a portion of the mesa 280 inside the contour of the BTJ region 250 serves as a high refractive index region, and a portion of the mesa 280 outside the contour of the BTJ region 250 serves as a low refractive index region.

The upper electrode 160 contacts an upper surface of the n-type DBR 242. The lower electrode 170 contacts the lower surface of the n-type GaAs substrate 110. The pair of the upper electrode 160 and the lower electrode 170 serves as an electrode pair.

In the third embodiment, a reverse bias is applied between the p-type DBR 241 and the n-type DBR 242, preventing current flow. Current flows between the p-type layer 251 and the n-type layer 252 due to buried tunnel junction. Thus, the current path between the upper electrode 160 and the lower electrode 170 is confined at the center of the mesa 280 including the BTJ region 250. Due to the BTJ region 250 forming a step and being covered by the n-type DBR 242, the refractive index in the plane of the mesa 280 is higher in the center and is lower around its periphery. This generates an optical confinement effect in the lateral direction in the surface-emitting laser 200.

Thus, also according to the third embodiment, an optical pulse can be output by injecting pulse current similar to that in the first embodiment and the second embodiment.

Fourth Embodiment

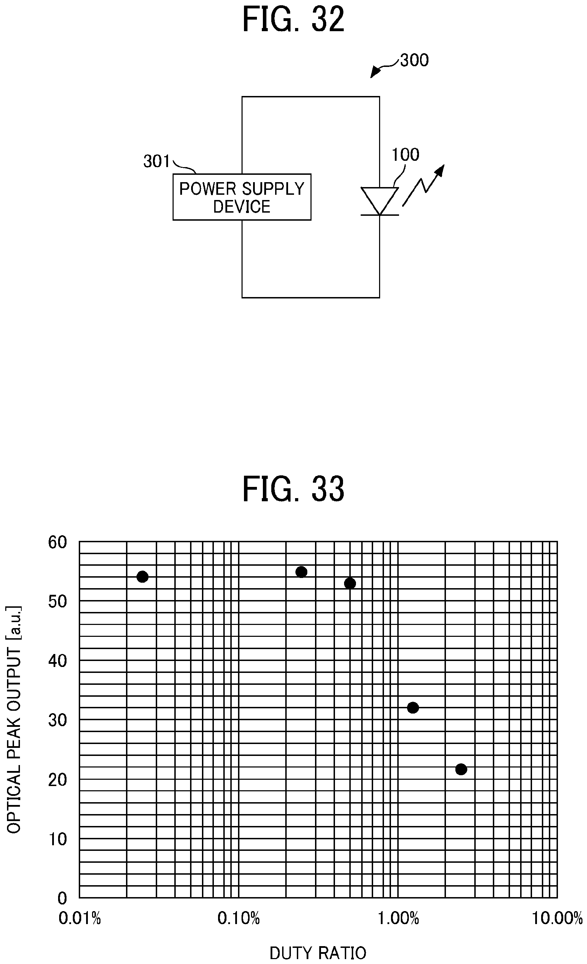

The fourth embodiment of the present disclosure is described below. The fourth embodiment relates to a laser device. FIG. 32 is a diagram of a laser device 300 according to the fourth embodiment.

The laser device 300 according to the fourth embodiment includes the surface-emitting laser 100 according to the first embodiment or the surface-emitting laser 100A according to the second embodiment and a power supply device 301 (or a power supply) connected to the upper electrode 160 and the lower electrode 170 of the surface-emitting laser 100 or the surface-emitting laser 100A. The power supply device 301 injects current to the surface-emitting laser 100 or the surface-emitting laser 100A.

The duty ratio of the injection of current from the power supply device 301 is preferably 0.5% or less. Preferably, the current injection period and the current decrease period are repeated multiple times, and the ratio of the current injection period to the current decrease period is 0.5% or less. The duty ratio is the ratio of time during which a current pulse is injected over a unit time period. When t (s) denotes the pulse current width and f (Hz) denotes the repetition frequency of the pulse current, the duty ratio corresponds to $f \times t$ (%).

FIG. 33 is a graph presenting the relation between the duty ratio and the peak output of optical pulses when the pulse current width is 2.5 ns.

As presented in FIG. 33, when the duty ratio exceeds 0.5%, the optical peak output tends to decrease. The following models can be considered as reasons for this trend. When the duty ratio is increased, the amount of heat generated in the current confinement region (non-oxidized region 152) by the injected pulse current increases. Thus, the temperature of the center portion where the current is concentrated rises with respect to the portion around the current confinement region, creating a temperature difference. Consequently, due to the thermal lens effect, the refractive index of the center portion of the current confinement region increases, and the optical confinement factor in the lateral direction increases. As the optical confinement factor in the lateral direction increases due to the thermal lens effect, the influence of a change in refractive index due to the carrier plasma effect generated by an increase or a decrease in pulse current decreases. Thus, the phenomenon in which the optical pulse is output immediately after the injection of the pulse current is stopped is less likely to occur. In contrast, with a duty ratio of 0.5% or less, the influence of refractive index changes due to thermal lens effects becomes sufficiently minimal, allowing the changes in refractive index attributable to the confinement structure to predominate. Thus, the peak output is expected to remain substantially unchanged.

In some embodiments, instead of the surface-emitting laser 100 according to the first embodiment or the surface-emitting laser 100A according to the second embodiment, the surface-emitting laser 200 according to the third embodiment may be used.

Fifth Embodiment

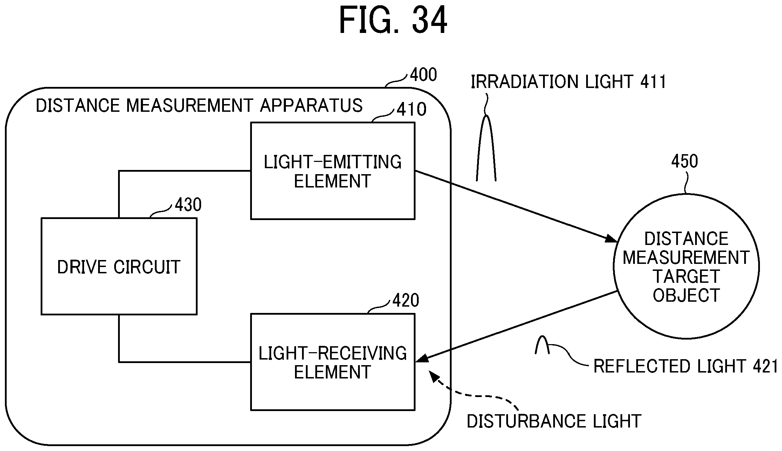

The fifth embodiment of the present disclosure is described below. The fifth embodiment relates to a distance measurement apparatus. FIG. 34 is a diagram of a distance measurement apparatus 400 according to the fifth embodiment. The distance measurement apparatus 400 serves as a detection device.

The distance measurement apparatus 400 according to the fifth embodiment is a distance measurement apparatus using a time of flight (TOF). The distance measurement apparatus 400 includes a light-emitting element 410, a light-receiving element 420, and a drive circuit 430. The light-emitting element 410 emits a light beam (irradiation light 411) to a distance-measurement target object 450 to which the distance is to be detected. The light-receiving element 420 receives the light (i.e., reflected light 421) reflected from the distance-measurement target object 450. The drive circuit 430 drives the light-emitting element 410 and measures the round-trip distance to the distance-measurement target object 450 by detecting the time difference between the emission timing of the light beam and the reception timing of the reflected light 421 by the light-receiving element 420.

The light-emitting element 410 includes the surface-emitting laser 100 according to the first embodiment or the surface-emitting laser 100A according to the second embodiment. The light-emitting element 410 may include multiple surface-emitting lasers 100 according to the first embodiment or multiple surface-emitting lasers 100A according to the second embodiment arranged in an array. The repetition frequency of the pulses is, for example, in the range from several kilohertz (kHz) to several tens of megahertz (MHz).

The light-receiving element 420 is, for example, a photodiode (PD), an avalanche photodiode (APD), or a single photon avalanche diode (SPAD). The light-receiving element 420 may include multiple light-receiving elements arranged in an array. The light-receiving element 420 serves as a detector.

In distance measurement using the TOF, it is desirable to separate the signal from the distance-measurement target object and noise from each other.

When measuring the distance to a more distant object or an object with a lower reflectance, it is preferable to use a more sensitive light-receiving element to obtain the signal from the object. However, using a more sensitive light-receiving element increases the possibility of mistakenly detecting background light noise or shot noise. To separate the signal from the noise, the threshold of the received signal may be increased. However, doing so would involve increasing the peak output of the emission beam; otherwise, the signal light from the distance-measurement target object becomes difficult to receive. However, the output of the emission beam is limited by the safety standards for lasers.

The surface-emitting laser 100 according to the first embodiment or the surface-emitting laser 100A according to the second embodiment can output optical pulses having a pulse width of about 100 ps. This is approximately 1/10 of the optical pulse width, in the range of several nanoseconds, output by the typical surface-emitting laser. According to the fifth embodiment, since the peak output allowable under the safety standard increases as the pulse width of the optical pulse decreases, both an increase in precision and an increase in distance can be attained while eye safety is satisfied.

Sixth Embodiment

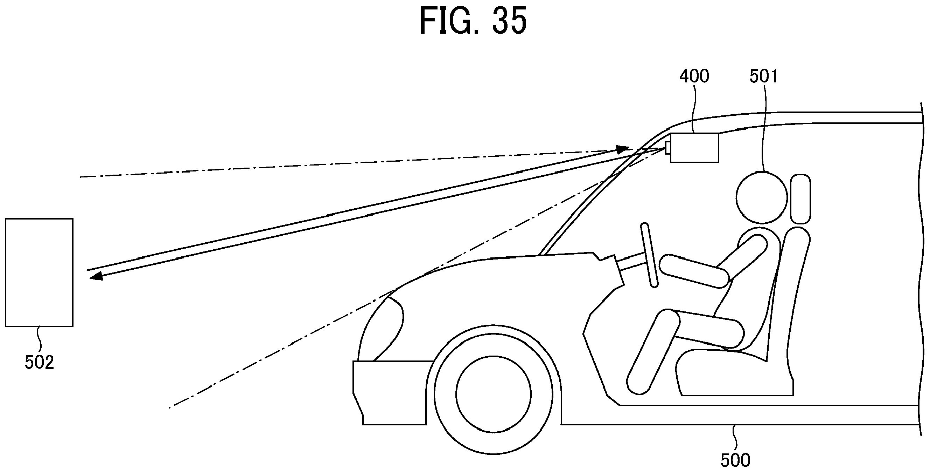

The sixth embodiment of the present disclosure is described below. The sixth embodiment relates to a mobile object. FIG. 35 is a diagram of a vehicle that serves as a mobile object according to the sixth embodiment. The distance measurement apparatus 400 according to the fifth embodiment is installed in the upper front side inside the vehicle 500 (for example, the upper portion of the front windshield) serving as a mobile object according to the sixth embodiment. The distance measurement apparatus 400 measures a distance to an object 502 around the vehicle 500. The measurement results of the distance measurement apparatus 400 are output to a controller included in the vehicle 500, and the controller controls the operation of the mobile object based on the measurement results. Alternatively, the controller, based on the measurement results of the distance measurement apparatus 400, may display a warning on a display inside the vehicle 500, directed toward a driver 501 of the vehicle 500.

As described above, in the sixth embodiment, the vehicle 500 incorporating the distance measurement apparatus 400 allows for high-precision recognition of nearby object 502. The installation position of the distance measurement apparatus 400 is not limited to the upper front portion of the vehicle 500 and may be installed on the side or rear of the vehicle 500. In the present embodiment, the distance measurement apparatus 400 is installed in the vehicle 500; however, the distance measurement apparatus 400 may be installed in aircraft or ships. Alternatively, the distance measurement apparatus 400 may be installed in mobile objects such as drones and robots that autonomously move without a driver.

Seventh Embodiment

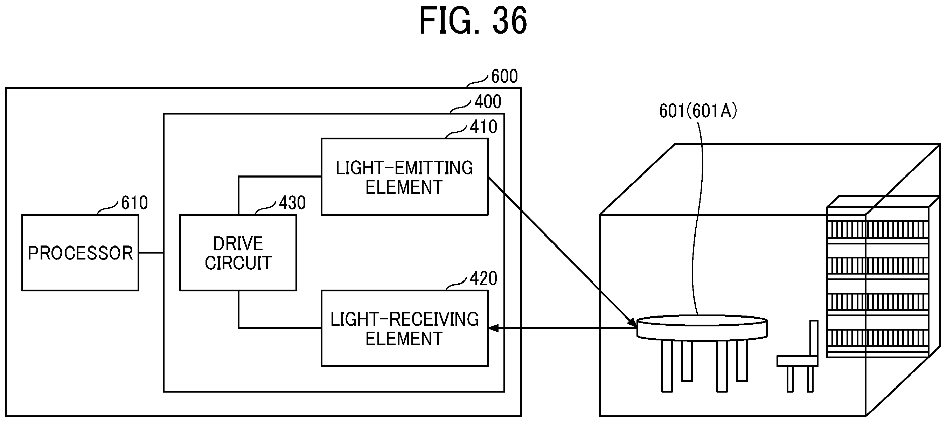

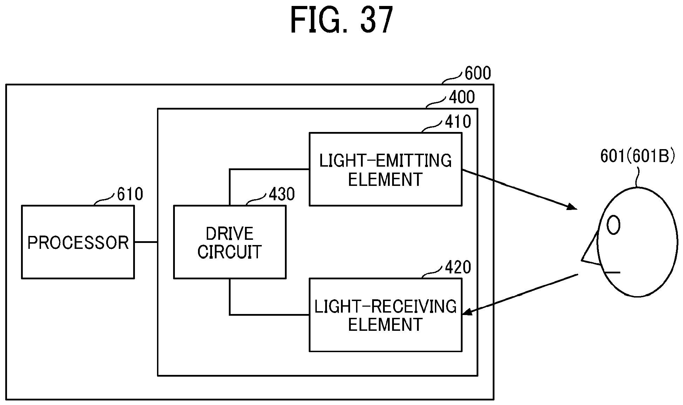

The seventh embodiment of the present disclosure is described below. The seventh embodiment relates to an information processing apparatus. FIGS. 36 and 37 are diagrams each illustrating the configuration of an information terminal apparatus 600 according to the seventh embodiment of the present disclosure. The information terminal apparatus 600 illustrated in FIGS. 36 and 37 detects, for example, an object 601 such as an object 601A or a human body 601B placed in a room.

As illustrated in FIGS. 36 and 37, the information terminal apparatus 600 includes a distance measurement apparatus 400 according to the fifth embodiment measures the distance to an object 601. The information terminal apparatus 600 includes a processor 610. The processor 610 calculates the distance to the object 601 based on a received-light signal of the reflection light that has entered the light-receiving element 420 of the distance measurement apparatus 400. The processor 610 is a computer including a central processing unit (CPU), a read-only memory (ROM), a random-access memory (RAM), a hard disk drive (HDD), and an input-output interface (I/F).

Although the desirable embodiments and so forth have been described in detail, the present disclosure is not limited to the above-described embodiments and so forth, and various modifications and substitutions can be made without departing from the scope and spirit of the present disclosure as set forth in the claims.

Aspects of the present disclosure are as follows.

Aspect 1

A surface-emitting laser includes a resonator and an electrode pair connected to a power supply, through which a current is injected into an active layer. The resonator includes the active layer to oscillate a laser beam; a first reflector; and a second reflector facing the first reflector with the active layer between the first reflector and the second reflector in a first direction (or in an emission direction of the laser beam emitted from the surface-emitting laser). The surface-emitting laser does not oscillate a laser beam during a current injection period in which the power supply injects the current into the active layer through the electrode pair, and oscillates and emits the laser beam during a current decrease period after the current injection period. The current injected into the active layer during the current decrease period is lower than the current injected into the active layer during the current injection period. The resonator has an optical thickness 1.5 times or more than a wavelength of the laser beam in a vacuum.

Aspect 2

A surface-emitting laser includes a resonator and an electrode pair connected to a power supply, through which a current is injected into an active layer. The resonator includes the active layer to oscillate a laser beam; a first reflector; and a second reflector facing the first reflector with the active layer between the first reflector and the second reflector in a first direction (or in an emission direction of the laser beam emitted from the surface-emitting laser). The laser beam emitted from the active layer has an optical pulse width that is a time width of $1/e^2$ of a peak value of the laser beam. The optical pulse width of the laser beam is smaller than a time width of a current injection period in which the power supply injects the current into the active layer. The optical pulse width of the laser beam is 110 ps or lower. The resonator has an optical thickness 1.5 times or more than a wavelength of the laser beam in a vacuum.

Aspect 3

In the surface-emitting laser according to Aspect 1 or 2, the resonator includes: a first spacer layer between the first reflector and the active layer; and a second spacer layer between the active layer and the second reflector.

Aspect 4

The surface-emitting laser according to any one of Aspects 1 to 3, further includes a first refractive index region having a first refractive index and a second refractive index region surrounding the first refractive index region and having a second refractive index lower than the first refractive index of the first refractive index region within a plane orthogonal to the vertical direction. The first refractive index region and the second refractive index region are within a plane orthogonal to the emission direction.

Aspect 5

In the surface-emitting laser, according to Aspect 4, the second refractive index region is formed by oxidation confinement. The first refractive index region has a first thickness of 35 nm or less. The second refractive index region has a second thickness that is twice or less of the first thickness at a position of 3 $\mu$m from a tip portion of a boundary between the first refractive index region and the second refractive index region.

Aspect 6

The surface-emitting laser according to Aspect 4, further includes a region surrounded by the tip portion of the boundary between the first refractive index region and the second refractive index region. The region has an area of 120 $\mu$m$^2$ or less within the plane orthogonal to the emission direction.

Aspect 7

A laser device includes the surface-emitting laser according to any one of Aspects 1 to 6; and the power supply connected to the electrode pair. The power supply injects the current into the surface-emitting laser.

Aspect 8

In the laser device according to Aspect 7, the current injection period and a current decrease period after the current injection period are repeated multiple times. The current injected into the active layer during the current decrease period is lower than the current injected into the active layer during the current injection period.

Aspect 9

A detection device includes the laser device according to Aspect 7 or 8; and a detector to detect light emitted from the surface-emitting laser and reflected from an object.

Aspect 10

The detection device according to Aspect 9, further includes a drive device configured to calculate a distance to the object based on a signal corresponding to the light detected by the detector.

Aspect 11

A mobile object includes the detection device according to Aspect 9 or 10.

Aspect 12

A mobile object includes the detection device according to Aspect 9 or 10.

Aspect 13

A method for driving a surface-emitting laser includes: oscillating no laser beam during a current injection period in which a power supply injects a current into an active layer; and oscillating a laser beam during a current decrease period after the current injection period. The current injected into the active layer during the current decrease period is lower than the current injected into the active layer during the current injection period. The surface-emitting laser includes a resonator and an electrode pair connected to a power supply, through which a current is injected into the active layer. The resonator includes an active layer, a first reflector, and a second reflector facing the first reflector with the active layer between the first reflector and the second reflector in a first direction. The surface-emitting laser does not emit a laser beam during a current injection period in which the power supply injects the current into the active layer through the electrode pair, and emits the laser beam during a current decrease period after the current injection period. The current injected into the active layer during the current decrease period is lower than the current injected into the active layer during the current injection period. The resonator has an optical thickness 1.5 times or more than a wavelength of the laser beam in a vacuum.

The above-described embodiments are illustrative and do not limit the present invention. Thus, numerous additional modifications and variations are possible in light of the above teachings. For example, elements and/or features of different illustrative embodiments may be combined with each other and/or substituted for each other within the scope of the present invention.

Any one of the above-described operations may be performed in various other ways, for example, in an order different from the one described above.

The present invention can be implemented in any convenient form, for example using dedicated hardware, or a mixture of dedicated hardware and software. The present invention may be implemented as computer software implemented by one or more networked processing apparatuses. The processing apparatuses include any suitably programmed apparatuses such as a general purpose computer, a personal digital assistant, a Wireless Application Protocol (WAP) or third-generation (3G)-compliant mobile telephone, and so on. Since the present invention can be implemented as software, each and every aspect of the present invention thus encompasses computer software implementable on a programmable device. The computer software can be provided to the programmable device using any conventional carrier medium (carrier means). The carrier medium includes a transient carrier medium such as an electrical, optical, microwave, acoustic or radio frequency signal carrying the computer code. An example of such a transient medium is a Transmission Control Protocol/Internet Protocol (TCP/IP) signal carrying computer code over an IP network, such as the Internet. The carrier medium may also include a storage medium for storing processor readable code such as a floppy disk, a hard disk, a compact disc read-only memory (CD-ROM), a magnetic tape device, or a solid state memory device.

**Claims**

1. A surface-emitting laser (100) comprising:

a resonator (100C1) including:

an active layer (130) to oscillate a laser beam;
a first reflector (120); and
a second reflector (140) facing the first reflector (120) with the active layer between the first reflector (120) and the second reflector (140) in an emission direction of the laser beam emitted from the surface-emitting laser,
the resonator (100C1) having an optical thickness 1.5 times or more than a wavelength of the laser beam in a vacuum; and

an electrode pair (160, 170) connected to a power supply, through which a current is injected into the active layer (130),
wherein the surface-emitting laser (100):

does not oscillate the laser beam during a current injection period in which the power supply injects the current into the active layer (130) through the electrode pair (160, 170); and
oscillates and emits the laser beam during a current decrease period after the current injection period, and the current injected into the active layer (130) during the current decrease period is lower than the current injected into the active layer (130) during the current injection period.

2. A surface-emitting laser (100) comprising:

a resonator (100C1) including:

an active layer (130) to oscillate a laser beam;
a first reflector (120); and
a second reflector (140) facing the first reflector (120) with the active layer between the first reflector (120) and the second reflector (140) in an emission direction of the laser beam emitted from the surface-emitting laser,
the resonator (100C1) having an optical thickness 1.5 times or more than a wavelength of the laser beam in a vacuum; and

an electrode pair (160, 170) connected to a power supply, through which a current is injected into the active layer (130),
wherein the active layer oscillates the laser beam having an optical pulse width that is:

a time width of $1/e^2$ of a peak value of the laser beam;
110 ps or lower; and
smaller than a time width of a current injection period in which the power supply injects the current into the active layer (130).

3. The surface-emitting laser (100) according to claim 1 or 2,
wherein the resonator (100C2) includes:

a first spacer layer (125) between the first reflector (120) and the active layer (130); and
a second spacer layer (145) between the active layer (130) and the second reflector (140).

4. The surface-emitting laser (100) according to any one of claims 1 to 3, further comprising:

a first refractive index region (152) having a first refractive index; and
a second refractive index region (151) surrounding the first refractive index region and having a second refractive index lower than the first refractive index of the first refractive index region,
wherein the first refractive index region and the second refractive index region are within a plane orthogonal to the emission direction.

**5.** The surface-emitting laser (100) according to claim 4,

wherein the second refractive index region is formed by oxidation confinement,
the first refractive index region has a first thickness of 35 nm or less, and
the second refractive index region has a second thickness that is twice or less of the first thickness at a position of 3 $\mu$m from a tip portion of a boundary between the first refractive index region and the second refractive index region.

**6.** The surface-emitting laser (100) according to claim 4 or 5, further comprising a region (152) surrounded by a tip portion of a boundary between the first refractive index region and the second refractive index region,
wherein the region has an area of 120 $\mu$m$^2$ or less within the plane orthogonal to the emission direction.

**7.** A laser device (300) comprising:

the surface-emitting laser according to any one of claims 1 to 6; and
the power supply (301) connected to the electrode pair (160, 170), the power supply (301) to inject the current into the surface-emitting laser (100).

**8.** The laser device (300) according to claim 7,

wherein the current injection period and a current decrease period after the current injection period are repeated multiple times, and
the current injected into the active layer (130) during the current decrease period is lower than the current injected into the active layer (130) during the current injection period.

**9.** A detection device (400) comprising:

the laser device (300) according to claim 7 or 8; and
a detector (420) to detect light emitted from the surface-emitting laser (100) and reflected from an object (450).

**10.** The detection device (400) according to claim 9, further comprising a drive circuit (430) configured to calculate a distance to the object based on a signal corresponding to the light detected by the detector (420).

**11.** A mobile object (500) comprising the detection device (400) according to claim 9 or 10.

**12.** An information terminal apparatus (600) comprising the detection device (400) according to claim 9 or 10.

**13.** A method for driving a surface-emitting laser, the method comprising:

oscillating no laser beam during a current injection period in which a power supply injects a current into an active layer; and
oscillating a laser beam during a current decrease period after the current injection period,
wherein the current injected into the active layer during the current decrease period is lower than the current injected into the active layer during the current injection period.

# FIG. 1

EP 4 435 982 A1

# FIG. 2

# FIG. 3

# FIG. 4

FIG. 5A

FIG. 5B

FIG. 5C

# FIG. 6A

# FIG. 6B

# FIG. 6C

EP 4 435 982 A1

# FIG. 7A

EQUIVALENT REFRACTIVE INDEX n

$\Delta n = (n1 - n0)$

n1
n0

ELECTRIC FIELD INTENSITY DISTRIBUTION

0    a    r

# FIG. 7B

EQUIVALENT REFRACTIVE INDEX n

$\Delta n = (n1 - n0)$

n1
n0

ELECTRIC FIELD INTENSITY DISTRIBUTION

0    a    r

# FIG. 8A

EQUIVALENT REFRACTIVE INDEX n

$\Delta n = (n2 - n0)$

n1
n2
n0

ELECTRIC FIELD INTENSITY DISTRIBUTION

0   a   r

# FIG. 8B

EQUIVALENT REFRACTIVE INDEX n

$\Delta n = (n1 - n0)$

n1

n0

ELECTRIC FIELD INTENSITY DISTRIBUTION

0   a   r

EP 4 435 982 A1

EP 4 435 982 A1

# FIG. 9

# FIG. 10

EP 4 435 982 A1

# FIG. 11

EP 4 435 982 A1

## FIG. 12

FIG. 13A

FIG. 13B

# FIG. 14A

EP 4 435 982 A1

# FIG. 14B

# FIG. 15A

# FIG. 15B

# FIG. 16

EP 4 435 982 A1

# FIG. 17A

# FIG. 17B

EP 4 435 982 A1

# FIG. 18

FIG. 19

FIG. 20

FIG. 21

# FIG. 22

CARRIER DENSITY [1/cm³]

OPTICAL CONFINEMENT FACTOR

REDUCTION AMOUNT OF REFRACTIVE INDEX n

○ SECOND MODEL (FIG. 20)

● THIRD MODEL (FIG. 21)

FIG. 23

# FIG. 24

THICKNESS OF THE OXIDIZED REGION AT POSITION $3\mu$m AWAY FROM BOUNDARY OUTWARD [nm]

● NO REDUCTION IN REFRACTIVE INDEX

○ REDUCTION AMOUNT OF REFRACTIVE INDEX: 0.006

# FIG. 25

# FIG. 26

EP 4 435 982 A1

## FIG. 27A

## FIG. 27B

# FIG. 28A

LONGITUDINAL MODE

# FIG. 28B

LONGITUDINAL MODE

# FIG. 28C

LONGITUDINAL MODE

# FIG. 28D

LONGITUDINAL MODE

EP 4 435 982 A1

## FIG. 29A

## FIG. 29B

# FIG. 30A

# FIG. 30B

# FIG. 31

# FIG. 32

# FIG. 33

# FIG. 34

DISTANCE MEASUREMENT APPARATUS 400

LIGHT-EMITTING ELEMENT 410

DRIVE CIRCUIT 430

LIGHT-RECEIVING ELEMENT 420

IRRADIATION LIGHT 411

DISTANCE MEASUREMENT TARGET OBJECT 450

REFLECTED LIGHT 421

DISTURBANCE LIGHT

EP 4 435 982 A1

FIG. 35

## FIG. 36

# FIG. 37

Europäisches
Patentamt

European
Patent Office

Office européen
des brevets

## EUROPEAN SEARCH REPORT

**Application Number**

EP 24 16 4203

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JIKUTANI NAOTO ET AL: "A new method for short pulse generation below 100 ps by controlling transverse mode distribution with free carrier plasma effect in an oxide-confined VCSEL", PROCEEDINGS OF THE SPIE, SPIE, US, vol. 12020, 3 March 2022 (2022-03-03), pages 1202004-1202004, XP060154194, ISSN: 0277-786X, DOI: 10.1117/12.2607989 ISBN: 978-1-5106-5738-0 | 1-13 | INV. H01S5/183 H01S5/062 H01S5/065 ADD. H01S5/00 H01S5/042 H01S5/10 H01S5/30 H01S5/323 |
| Y | * page 12020041, paragraph 1 - page 12020047, paragraph 3; figures 1-6; table 1 * | 5 | |
| X | WO 2022/244674 A1 (CANON KK [JP]) 24 November 2022 (2022-11-24) | 2-4,6-12 | |
| Y | * paragraphs [0013] - [0127]; figures 1-18 * -& US 2024/085534 A1 (UCHIDA TAKESHI [JP] ET AL) 14 March 2024 (2024-03-14) * paragraphs [0031] - [0144]; figures 1-18 * | 5 | |
| X | LIN J ET AL: "SHORT PULSE GENERATION BY ELECTRICAL GAIN SWITCHING OF VERTICAL CAVITY SURFACE EMITTING LASER", ELECTRONICS LETTERS, THE INSTITUTION OF ENGINEERING AND TECHNOLOGY, GB, vol. 27, no. 21, 10 October 1991 (1991-10-10), pages 1956-1958, XP000253969, ISSN: 0013-5194 * page 1956, right-hand column, paragraph 1 - page 1957, right-hand column, paragraph 2; figures 1-3 * | 1-4,7-9, 13 | |

-----

-/--

**TECHNICAL FIELDS SEARCHED (IPC)**

H01S

The present search report has been drawn up for all claims

| Place of search | Date of completion of the search | Examiner |
|---|---|---|
| Munich | 23 July 2024 | Laenen, Robert |

EPO FORM 1503 03.82 (P04C01)

| | Europäisches Patentamt European Patent Office Office européen des brevets | **EUROPEAN SEARCH REPORT** | **Application Number** EP 24 16 4203 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 6 943 939 B1 (DIJAILI SOL P [US] ET AL) 13 September 2005 (2005-09-13) * column 2, line 37 - column 10, line 60; figures 1-7 * | 1,2 | |
| | | | **TECHNICAL FIELDS SEARCHED (IPC)** |

The present search report has been drawn up for all claims

| Place of search | Date of completion of the search | Examiner |
|---|---|---|
| Munich | 23 July 2024 | Laenen, Robert |

EPO FORM 1503 03.82 (P04C01)

## ANNEX TO THE EUROPEAN SEARCH REPORT
## ON EUROPEAN PATENT APPLICATION NO.

EP 24 16 4203

This annex lists the patent family members relating to the patent documents cited in the above-mentioned European search report.
The members are as contained in the European Patent Office EDP file on
The European Patent Office is in no way liable for these particulars which are merely given for the purpose of information.

23-07-2024

| Patent document cited in search report | | Publication date | Patent family member(s) | | Publication date |
|---|---|---|---|---|---|
| WO 2022244674 | A1 | 24-11-2022 | EP | 4343990 A1 | 27-03-2024 |
| | | | KR | 20230164160 A | 01-12-2023 |
| | | | US | 2024085534 A1 | 14-03-2024 |
| | | | WO | 2022244674 A1 | 24-11-2022 |
| US 2024085534 | A1 | 14-03-2024 | EP | 4343990 A1 | 27-03-2024 |
| | | | KR | 20230164160 A | 01-12-2023 |
| | | | US | 2024085534 A1 | 14-03-2024 |
| | | | WO | 2022244674 A1 | 24-11-2022 |
| US 6943939 | B1 | 13-09-2005 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **KOBAYASHI, SOICHI et al.** Direct frequency modulation in AlGaAs semiconductor lasers. *IEEE Transactions on Microwave Theory and Techniques,* 1982, vol. 30 (4), 428-441